(19) Europäisches Patentamt
European Patent Office
Office européen des brevets

(11) EP 4 722 810 A1

(12) **EUROPEAN PATENT APPLICATION**
published in accordance with Art. 153(4) EPC

(43) Date of publication:
**08.04.2026 Bulletin 2026/15**

(21) Application number: **24811145.2**

(22) Date of filing: **22.05.2024**

(51) International Patent Classification (IPC):
***G03F 7/004*** *(2006.01)* ***G03F 7/20*** *(2006.01)*
***G03F 7/029*** *(2006.01)*

(52) Cooperative Patent Classification (CPC):
**G03F 7/004; G03F 7/029; G03F 7/20**

(86) International application number:
**PCT/JP2024/018849**

(87) International publication number:
**WO 2024/242139 (28.11.2024 Gazette 2024/48)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **24.05.2023 JP 2023085569**
**29.11.2023 JP 2023202023**

(71) Applicant: **Tokyo Ohka Kogyo Co., Ltd.**
**Kawasaki-shi, Kanagawa 211-0012 (JP)**

(72) Inventors:
- **INARI, Takatoshi**
**Kawasaki-shi, Kanagawa 211-0012 (JP)**
- **NODA, Kunihiro**
**Kawasaki-shi, Kanagawa 211-0012 (JP)**
- **KUBO, Keisuke**
**Kawasaki-shi, Kanagawa 211-0012 (JP)**
- **KIMURA, Kenta**
**Kawasaki-shi, Kanagawa 211-0012 (JP)**
- **NISHIZAWA, Akito**
**Kawasaki-shi, Kanagawa 211-0012 (JP)**
- **KINOSHITA, Yohei**
**Kawasaki-shi, Kanagawa 211-0012 (JP)**
- **WAKIYA, Kazumasa**
**Kawasaki-shi, Kanagawa 211-0012 (JP)**
- **UNO, Kakishi**
**Kawasaki-shi, Kanagawa 211-0012 (JP)**

(74) Representative: **Plasseraud IP**
**104 Rue de Richelieu**
**CS92104**
**75080 Paris Cedex 02 (FR)**

(54) **RESIST MATERIAL, PATTERN FORMING METHOD, AND PATTERNED STRUCTURE**

(57) To provide a novel resist material containing a polyacid salt, a pattern forming method, and a patterned structure.

**Fig. 1**

<LS pattern 1>

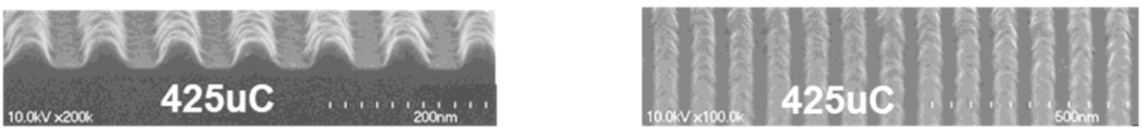


(Cross section) (Upper surface)

EP 4 722 810 A1

## Description

### Technical Field

The present invention relates to a resist material, a pattern forming method, and a patterned structure.

### Background Art

A polyacid is an anionic metal oxide cluster and has a structure in which an early transition metal with an electron configuration of $d^0$ or $d^1$ (for example, Mo (hexavalent or pentavalent), W (hexavalent or pentavalent), V (pentavalent), Nb (pentavalent), Ta (pentavalent), or the like) is oxygen-cross-linked.
Various structures can be adopted by incorporating various elements into the anionic metal oxide cluster of polyacid. Depending on the combination of constituent elements of polyacid, the structure thereof, and the like, physicochemical properties, such as oxidation-reduction ability, light absorption ability, and acidity, can be changed.
For example, Patent Literature 1 describes that a polyacid salt containing polyoxomolybdic acid and a compound with a pyridinium skeleton has a high photoluminescence quantum yield.

### Citation List

### Patent Literature

PTL 1: U.S. Patent No. 11192908

### Summary of Invention

### Technical Problem

The present invention has been made in view of such circumstances and aims to provide a novel resist material containing a polyacid salt, a pattern forming method, and a patterned structure.

### Solution to Problem

As a result of extensive studies to solve the above problems, the present inventors have completed the present invention by finding that a polyacid salt can be used for an application as a resist material and finding a method for forming a pattern of a resist material containing a polyacid salt.
More specifically, the present invention relates to the following inventions.

[1] A resist material containing a polyacid salt.
[2] The resist material according to [1], wherein the polyacid salt is a salt with an onium cation.
[3] The resist material according to [1], wherein the polyacid salt is a salt with an onium cation, and the onium cation has at least one optionally substituted unsaturated bond.
[4] The resist material according to [1], further containing an organic solvent.
[5] The resist material according to [4], wherein the organic solvent is a polar solvent.
[6] The resist material according to [1], wherein the polyacid salt is a salt of an isopolyoxomolybdate anion, an isopolyoxotungstate anion, an isopolyoxoniobate anion, an isopolyoxotantalate anion, a heteropolyoxomolybdate anion, a heteropolyoxotungstate anion, a heteropolyoxovanadate anion, a heteropolyoxoniobate anion, or a heteropolyoxotantalate anion, and an organic sulfonium cation, an organic iodonium cation, or an organic quaternary ammonium cation.
[7] A pattern forming method including the steps of: forming a resist film using the resist material according to any one of [1] to [6]; exposing the resist film to light; and developing the exposed resist film with a developer.
[8] The pattern forming method according to [7], wherein the step of exposing the resist film to light includes a step of exposing the resist film to an electron beam at a dose of 2 $mC/cm^2$ or less or extreme ultraviolet of 200 $mJ/cm^2$ or less.
[9] The pattern forming method according to [7], wherein the developer contains an amide solvent, an ester solvent, a ketone solvent, or an alcohol solvent.
[10] A pattern forming method including the steps of: forming a resist film using the resist material according to any one of [1] to [6]; exposing the resist film to light; and developing the exposed resist film by dry etching.
[11] The pattern forming method according to [10], wherein in the step of developing by dry etching, a gas containing a halogen-containing gas is used as an etching gas.

[12] The pattern forming method according to [11], wherein the halogen-containing gas is fluorocarbon, hydrofluorocarbon, a fluorine-based gas, a chlorine-based gas, or a bromide-based gas.
[13] A patterned structure obtained by patterning the resist material according to any one of [1] to [6].
[14] A patterned structure, wherein the patterned structure according to [13] has a portion with an average thickness in the range of 10 to 100 nm.
[15] A patterned structure, wherein the patterned structure according to [13] includes a portion having a pitch of 100 nm or less.
[16] The resist material according to any one of [1] to [6], which is a resist material for an electron beam or EUV.

## Advantageous Effects of Invention

The present invention can provide a novel resist material containing a polyacid salt, a pattern forming method, and a patterned structure. A resist material according to the present invention contains a polyacid salt that can highly absorb a light source, such as DUV, XUV, EUV, or an electron beam, and can therefore be suitably used as a resist material for these exposure light sources.

## BRIEF DESCRIPTION OF THE FIGURES

[Fig. 1] Fig. 1 shows SEM images of a cross section and an upper surface of an LS pattern 1.
[Fig. 2] Fig. 2 shows SEM images of a cross section and an upper surface of an LS pattern 2.

## Description of Embodiments

Preferred embodiments of the present invention will be described in detail below. However, the present invention is not limited to the following embodiments.

[1. Resist Material]

A resist material according to the present embodiment contains a polyacid salt. The resist material may contain an organic solvent.
Meanings of terms, symbols, and the like used in the present description will be described below, and embodiments of the present invention will be described in more detail below.
The term "halogen atom", as used herein, refers to a fluorine atom, a chlorine atom, a bromine atom, or an iodine atom.
In the present description, for example, the term "$C_1$-$_6$" or the like means the number of carbon atoms of a group serving as a mother nucleus.
The term "$C_1$-$_{18}$ hydrocarbylene group", as used herein, refers to a divalent hydrocarbon group formed by removing two hydrogen atoms from a hydrocarbon with 1 to 18 carbon atoms. The hydrocarbylene group may be linear, branched, or partially or fully cyclic. Examples of the hydrocarbylene group include an alkylene group and an arylene group.
A divalent carbon atom at any position of the "$C_1$-$_{18}$ hydrocarbylene group" may be replaced by -O-, -S-, -C(=O)-, -COO-, -OCO-, -CONH-, -NHCO-, -NH(C=O)O-, -S-, - SO-, or -$SO_2$- (provided that adjacent divalent carbon atoms are not replaced at the same time).
The "$C_1$-$_{18}$ hydrocarbylene group" is, for example, but not limited to, a "$C_1$-$_{18}$ alkylene group", such as a methylene group, an ethylene group, a n-propylene group, an i-propylene group, a cyclopentadiyl group, a cyclohexanediyl group, an oxyethane-1,1-diyl group, an oxyethane-1,2-diyl group, an oxypropane-1,3-diyl group, an oxypropane-1,2-diyl group, a 2-methylpropane-1,3-diyl group, or an oxyethyleneoxyethane-1,1-diyl group; a "$C_{6-18}$ arylene group", such as a 1,4-phenylene group, a 1,3-phenylene group, a 1,2-phenylene group, a 1,4-naphthylene group, a 1,5-naphthylene group, a 1,8-naphthylene group, a 4,4'-biphenylene group, an anthracenediyl group, a phenanthrenediyl group, a naphthacenediyl group, a pyrenediyl group, a perylenediyl group, or a chrysenediyl group; or the like.
The term "$C_1$-$_{18}$ alkyl group", as used herein, refers to a linear or branched alkyl group with 1 to 18 carbon atoms.
Furthermore, a divalent carbon atom at any position excluding the terminals contained in the "$C_1$-$_{18}$ alkyl group" may be replaced by -O-, -C(=O)-, -C(=O)O-, -OCO-, -CONH-, -NHCO-, -NH(C=O)O-, -S-, or -$SO_2$-. However, adjacent divalent carbon atoms are not replaced at the same time.
The "$C_1$-$_{18}$ alkyl group" is, for example, but not limited to, a methyl group, an ethyl group, a n-propyl group, an i-propyl group, a n-butyl group, an i-butyl group, a sec-butyl group, a t-butyl group, a n-pentyl group, an i-pentyl group, a sec-pentyl group, a t-pentyl group, a neopentyl group, a 1-methylbutyl group, a 2-methylbutyl group, a 1,1-dimethylpropyl group, a 1,2-dimethylpropyl group, a n-hexyl group, an i-hexyl group, a 1-methylpentyl group, a 2-methylpentyl group, a 3-methylpentyl group, a 1,1-dimethylbutyl group, a 1,2-dimethylbutyl group, a 2,2-dimethylbutyl group, a 1,3-dimethylbutyl group, a 2,3-dimethylbutyl group, a 3,3-dimethylbutyl group, a 1-ethylbutyl group, a 2-ethylbutyl group, a 1,1,2-trimethylpropyl group, a 1,2,2-trimethylpropyl group, a 1-ethyl-1-methylpropyl group, a 1-ethyl-2-methylpropyl group, a n-heptyl group, a n-octyl group, a n-nonyl group, a n-decyl group, a n-undecyl group, a n-dodecyl group, or the like.

The "$C_1$-$_{18}$ alkyl group" in which a divalent carbon atom at any position excluding the terminals thereof is replaced by -O-, -C(=O)-, -C(=O)O-, -OCO-, -CONH-, -NHCO-, - NH(C=O)O-, -S-, or -$SO_2$- is, for example, but not limited to, a 2-methoxyethoxymethyl group, an ethoxycarbonylmethyl group, or the like.

The term "$C_1$-$_{18}$ haloalkyl group", as used herein, refers to a group in which one or more hydrogen atoms of the "$C_1$-$_{18}$ alkyl group" are substituted by a halogen atom.

The "$C_1$-$_{18}$ haloalkyl group" is, for example, but not limited to, a dichloromethyl group, a trifluoromethyl group, a 2,2-difluoroethyl group, a 2,2,2-trifluoroethyl group, a pentafluoroethyl group, a 3,3,3-trifluoropropyl group, or the like.

The term "$C_{2-18}$ alkenyl group", as used herein, refers to an alkenyl group with 2 or more carbon atoms having one or more double bonds in the "$C_1$-$_{18}$ alkyl group" and includes an alkadienyl group, an alkatrienyl group, and the like.

The "$C_{2-18}$ alkenyl group" is, for example, but not limited to, a vinyl group (ethenyl group), an allyl group (2-propenyl group), a 1-propenyl group, an isopropenyl group (1-methyl vinyl group), a 1-butenyl group, a 2-butenyl group, a 3-butenyl group, a pentenyl group, a hexenyl group, a heptenyl group, an octenyl group, a nonenyl group, a decenyl group, an undecenyl group, a dodecenyl group, or the like.

The term "$C_{2-18}$ alkynyl group", as used herein, refers to an alkynyl group with 2 or more carbon atoms having one or more triple bonds in the "$C_1$-$_{18}$ alkyl group".

The "$C_{2-18}$ alkynyl group" is, for example, but not limited to, an ethynyl group, a 1-propynyl group, a 2-propynyl group, a pentynyl group, a hexynyl group, a heptynyl group, an octynyl group, a nonynyl group, a decynyl group, an undecynyl group, a dodecynyl group, or the like.

The term "$C_{3-18}$ alicyclic group", as used herein, refers to a hydrocarbon group with 3 to 18 carbon atoms and with a monocyclic or polycyclic structure in whole or in part. The alicyclic group includes a cycloalkyl group, a cycloalkenyl group, a cycloalkynyl group, a monocycloalkyl group, a polycycloalkyl group, and the like.

A divalent carbon atom at any position excluding the terminals contained in the "$C_{3-18}$ alicyclic group" may be replaced by -O-, -C(=O)-, -C(=O)O-, -OCO-, -CONH-, - NHCO-, -NH(C=O)O-, -S-, or -$SO_2$- (provided that adjacent divalent carbon atoms are not replaced at the same time).

The "$C_{3-18}$ cycloalkyl group" is, for example, but not limited to, a cyclopropyl group, a cyclobutyl group, a cyclopentyl group, a 1-i-propylcyclopentane-1-yl group, a cyclohexyl group, a t-butylcyclohexyl group, a tricyclodecanyl group, a cycloheptyl group, a cyclooctyl group, a cyclodecyl group, a 2-methyladamantane-2-yl group, a 2-i-propyladamantane-2-yl group, a bornyl group, a norbonyl group, a fenchyl group, a pinanyl group, an adamantyl group, a tricyclodecyl group, a tetracyclododecyl group, a cyclopropylmethyl group, a cyclobutylmethyl group, a cyclopentylmethyl group, a cyclohexylmethyl group, a bornylmethyl group, a norbornylmethyl group, an adamantylmethyl group, a 1-methylcyclopentyloxycarbonylmethyl group, a cyclopentenyl group, a cyclohexenyl group, a cycloheptenyl group, or the like.

The term "3- to 18-membered non-aromatic heterocyclic group", as used herein, refers to a 3- to 18-membered non-aromatic heterocyclic group containing one or more heteroatoms selected from the group consisting of a nitrogen atom, an oxygen atom, and a sulfur atom, may be monocyclic, polycyclic, or condensed, and may be saturated or partially unsaturated.

The "3- to 18-membered non-aromatic heterocyclic group" is, for example, but not limited to, an aziridinyl group, an azetidil group, a pyrrolidinyl group, a pyrrolyl group, a piperidinyl group, a piperazinyl group, a morpholinyl group, a thiomorpholinyl group, a tetrahydrofuryl group, a tetrahydropyranyl group, an oxetanyl group, a tetrahydrofuryl group, a tetrahydropyranyl group, an imidazolinyl group, an oxazolinyl group, a 2,5-diazabicyclo[2.2.1]heptyl group, a 2,5-diazabicyclo[2.2.2]octyl group, a 3,8-diazabicyclo[3.2.1]octyl group, a 1,4-diazabicyclo[4.3.0]nonyl group, a 1-azaadamantyl group, a 2-azaadamantyl group, or the like.

The term "$C_{2-18}$ aryl group", as used herein, refers to an aromatic hydrocarbon ring group with 6 to 18 carbon atoms or an aromatic heterocyclic group with 2 to 10 carbon atoms; in the case of an aromatic heterocyclic group, 2 to 10 carbon atoms and one or more heteroatoms selected from the group consisting of a nitrogen atom, an oxygen atom, and a sulfur atom form a ring, and the ring may be monocyclic, polycyclic, or a fused ring.

The "$C_{2-18}$ aryl group" is, for example, but not limited to, a phenyl group, a 1-naphthyl group, a 2-naphthyl group, an azulenyl group, a pentalenyl group, a heptalenyl group, an indacenyl group, an acenaphthyl group, a phenanthrenyl group, an anthracenyl group, or the like.

The term "$C_{7-18}$ aralkyl group", as used herein, refers to a group in which a substitutable portion of a "$C_{1-12}$ alkyl group" is substituted by the "$C_{2-12}$ aryl group".

The "$C_{7-18}$ aralkyl group" is, for example, but not limited to, a benzyl group, a phenethyl group, a 3-phenylpropyl

group, a 4-phenylbutyl group, a 1-naphthylmethyl group, or a 2-naphthylmethyl group, or the like.

The term "$C_1$-$_{18}$ hydrocarbyl group", as used herein, refers to a monovalent group formed by removing one hydrogen atom from a hydrocarbon with 1 to 18 carbon atoms. Examples of the hydrocarbyl group include an alkyl group, an alkenyl group, an alkynyl group, an alicyclic group, an aryl group, an aralkyl group, and the like.

A divalent carbon atom at any position excluding the terminals contained in the "$C_1$-$_{18}$ hydrocarbyl group" may be replaced by -O-, -C(=O)-, -C(=O)O-, -OCO-, -CONH-, -NHCO-, -NH(C=O)O-, -S-, or -$SO_2$- (provided that adjacent divalent carbon atoms are not replaced at the same time).

The "$C_1$-$_{18}$ hydrocarbyl group" is, for example, but not limited to, a "$C_1$-$_{18}$ alkyl group", a "$C_{2-18}$ alkenyl group", a "$C_{2-18}$ alkynyl group", a "$C_{3-18}$ alicyclic group", a "$C_{2-18}$ aryl group", a "$C_{7-18}$ aralkyl group", or the like.

The term "$C_1$-$_{18}$ hydrocarbyloxy group", as used herein, refers to a group in which an oxygen atom (-O-) is bonded to the "$C_1$-$_{18}$ hydrocarbyl group".

The "$C_1$-$_{18}$ hydrocarbyloxy group" is, for example, but not limited to, a "$C_1$-$_{18}$ alkoxy group", such as a methoxy group, an ethoxy group, a n-propoxy group, an i-propoxy group, a n-butoxy group, an i-butoxy group, a sec-butoxy group, a t-butoxy group, a n-pentoxy group, an i-pentoxy group, a sec-pentoxy group, a n-hexoxy group, an i-hexoxy group, a 1,1-dimethylpropyloxy group, a 1,2-dimethylpropyloxy group, a 2,2-dimethylpropyloxy group, a 1-methyl-2-ethylpropyloxy group, a 1-ethyl-2-methylpropyloxy group, a 1,1,2-trimethylpropyloxy group, a 1,2,2-trimethylpropyloxy group, a 1,1-dimethylbutyloxy group, a 1,2-dimethylbutyloxy group, a 2,2-dimethylbutyloxy group, a 2,3-dimethylbutyloxy group, a 1,3-dimethylbutyloxy group, a 2-ethylbutyloxy group, a 2-methylpentyloxy group, or a 3-methylpentyloxy group; a "$C_{3-18}$ alicyclic oxy group", such as a cyclopropyloxy group, a cyclobutyloxy group, a cyclopentyloxy group, a cyclohexyloxy group, a cycloheptyloxy group, a cyclooctyloxy group, a 1-methylcyclopentyloxycarbonylmethoxy group, a 1-ethylcyclohexyloxycarbonylmethoxy group, or a 1-methyladamantyloxycarbonylmethoxy group; a "$C_{6-18}$ aryloxy group", such as a phenyloxy group, a 1-naphthyloxy group, a 2-naphthyloxy group, an azulenyloxy group, a pentalenyloxy group, a heptalenyloxy group, an indacenyloxy group, an acenaphthyloxy group, a phenanthrenyloxy group, or an anthracenyloxy group; or the like.

In the "$C_1$-$_{18}$ hydrocarbyloxy group", a divalent carbon atom at any position excluding the terminals in the "$C_1$-$_{18}$ hydrocarbyl group" is preferably replaced by -O-, - C(=O)-, and/or -C(=O)O-, the "$C_1$-$_{18}$ hydrocarbyloxy group" is more preferably a "$C_1$-$_{18}$ hydrocarbyloxycarbonylalkyloxy group", and from the perspective of solubility, a carbon atom bonded to the oxygen atom of the hydrocarbyloxy is still more preferably a tertiary carbon. Specific examples of the hydrocarbyloxy include optionally substituted ethylcyclopentyloxy, methyladamantyloxy, ethyladamantyloxy, t-butyloxy, and the like.

The term "$C_1$-$_{18}$ hydrocarbylcarbonyl group", as used herein, refers to a group in which a carbonyl group (-C(=O)-) is bonded to the "$C_1$-$_{18}$ hydrocarbyl group".

The "$C_1$-$_{18}$ hydrocarbylcarbonyl group" is, for example, but not limited to, a "$C_1$-$_{18}$ alkyl carbonyl group", such as an acetyl group, a propionyl group, an isopropionyl group, a butyryl group, an isobutyryl group, a valeryl group, an isovaleryl group, a pentanoyl group, a 3-methylbutanoyl group, a pivaloyl group, a hexanoyl group, or a heptanoyl group; a "$C_{3-18}$ alicyclic carbonyl group", such as a cyclopropyl carbonyl group, a cyclobutyl carbonyl group, a cyclopentyl carbonyl group, a 2-methylcyclopentyl carbonyl group, a 3-methylcyclopentyl carbonyl group, a cyclohexyl carbonyl group, a 2-methylcyclohexyl carbonyl group, a 3-methylcyclohexyl carbonyl group, a 4-methylcyclohexyl carbonyl group, or an adamantyl carbonyl group; a "$C_{6-18}$ aryl carbonyl group", such as a benzoyl group, a 1-naphthoyl group, or a 2-naphthoyl group; or the like.

The term "$C_1$-$_{18}$ hydrocarbylcarbonyloxy group", as used herein, refers to a group in which an oxygen atom (-O-) is bonded to the "$C_1$-$_{18}$ hydrocarbylcarbonyl group".

The "$C_1$-$_{18}$ hydrocarbylcarbonyloxy group" is, for example, but not limited to, a "$C_1$-$_{18}$ alkyl carbonyloxy group", such as a methyl carbonyloxy group, an ethyl carbonyloxy group, a n-propyl carbonyloxy group, an isopropyl carbonyloxy group, a n-butyl carbonyloxy group, an isobutyl carbonyloxy group, a t-butyl carbonyloxy group, a n-pentyl carbonyloxy group, an isopentyl carbonyloxy group, or a hexyl carbonyloxy group; a "$C_{3-18}$ alicyclic carbonyloxy group", such as a cyclopropyl carbonyloxy group, a cyclobutyl carbonyloxy group, a cyclopentyl carbonyloxy group, or a cyclohexyl carbonyloxy group; a "$C_{6-18}$ aryl carbonyloxy group", such as a phenyl carbonyloxy group, a naphthyl carbonyloxy group, an acenaphthyl carbonyloxy group, a phenanthrenyl carbonyloxy group, or an anthracenyl carbonyloxy group; or the like.

The term "$C_1$-$_{18}$ hydrocarbyloxycarbonyl group", as used herein, refers to a group in which a carbonyl group (-C(=O)-) is bonded to a "$C_1$-$_{18}$ hydrocarbyloxy group".

The "$C_1$-$_{18}$ hydrocarbyloxycarbonyl group" is, for example, but not limited to, a "$C_1$-$_{18}$ alkoxycarbonyl group", such as a methoxycarbonyl group, an ethoxycarbonyl group, a n-propoxycarbonyl group, an i-propoxycarbonyl group, a n-butoxycarbonyl group, an i-butoxycarbonyl group, a sec-butoxycarbonyl group, a t-butoxycarbonyl group, a n-pentoxycarbonyl group, or a neopentyloxycarbonyl group; a "$C_{3-18}$ alicyclic oxycarbonyl group", such as a cyclopropyloxycarbonyl group, a cyclobutyloxycarbonyl group, a cyclopentyloxycarbonyl group, a cyclohexyloxycarbonyl group, a 2-methylcyclopentyloxycarbonyl group, a 3-methylcyclopentyloxycarbonyl group, a 2-methylcyclohexyloxycarbonyl group, a 3-methylcyclohexyloxycarbonyl group, or a 4-methylcyclohexyloxycarbonyl group; a "$C_{6-18}$ aryloxycarbonyl group", such as a phenoxycarbonyl group, a naphthoxycarbonyl group, an acenaphthyloxycarbonyl group, a phenanthrenyloxycarbonyl group, or an anthracenyloxycarbonyl group; or the like.

The term "$C_1$-$_{18}$ hydrocarbyloxycarbonyloxy group", as used herein, refers to a group in which an oxygen atom (-O-) is bonded to the "$C_1$-$_{18}$ hydrocarbyloxycarbonyl group".

The "$C_1$-$_{18}$ hydrocarbyloxycarbonyloxy group" is, for example, but not limited to, a "$C_1$-$_{18}$ alkoxycarbonyloxy group", such as a methoxycarbonyloxy group, an ethoxycarbonyloxy group, a n-propyloxycarbonyloxy group, an i-propyloxycarbonyloxy group, a n-butoxycarbonyloxy group, an i-butoxycarbonyloxy group, a sec-butoxycarbonyloxy group, a t-butoxycarbonyloxy group, a n-pentyloxycarbonyloxy group, an i-pentyloxycarbonyloxy group, or a n-hexyloxycarbonyloxy group; a "$C_{3-18}$ alicyclic oxycarbonyloxy group", such as a cyclopropyloxycarbonyloxy group, a cyclobutyloxycarbonyloxy group, a cyclopentyloxycarbonyloxy group, or a cyclohexyloxycarbonyloxy group; a "$C_{6-18}$ aryloxycarbonyloxy group", such as a phenoxycarbonyloxy group, a naphthoxycarbonyloxy group, an acenaphthyloxycarbonyloxy group, a phenanthrenyloxycarbonyloxy group, or an anthracenyloxycarbonyloxy group; or the like.

The term "$C_1$-$_{18}$ hydrocarbylamino group", as used herein, refers to a group in which one "$C_1$-$_{18}$ hydrocarbyl group" is bonded to an amino group.

The "$C_1$-$_{18}$ hydrocarbylamino group" is, for example, but not limited to, a "$C_1$-$_{18}$ alkylamino group", such as a methylamino group, an ethylamino group, a n-propylamino group, an i-propylamino group, a n-butylamino group, an i-butylamino group, a sec-butylamino group, a t-butylamino group, a n-pentylamino group, an i-pentylamino group, a neopentylamino group, or a n-hexylamino group; a "$C_{3-18}$ alicyclic amino group", such as a cyclopropylamino group, a cyclobutylamino group, a cyclopentylamino group, a 2-methylcyclopentylamino group, a 3-methylcyclopentylamino group, a cyclohexylamino group, a 2-methylcyclohexylamino group, a 3-methylcyclohexylamino group, or a 4-methylcyclohexylamino group; a "$C_{6-18}$ arylamino group", such as a phenylamino group, a 1-naphthylamino group, or a 2-naphthylamino group; or the like.

The term "di-$C_1$-$_{18}$ hydrocarbylamino group", as used herein, refers to a group in which two identical or different "$C_1$-$_{18}$ hydrocarbyl groups" are bonded to an amino group.

The "di-$C_1$-$_{18}$ hydrocarbylamino group" is, for example, but not limited to, a "di-$C_1$-$_{18}$ alkylamino group", such as a dimethylamino group, a diethylamino group, a di-n-propylamino group, a diisopropylamino group, a di-n-butylamino group, a diisobutylamino group, a di-t-butylamino group, a di-n-pentylamino group, a di-n-hexylamino group, an N-ethyl-N-methylamino group, an N-methyl-N-n-propylamino group, an N-isopropyl-N-methylamino group, an N-n-butyl-N-methylamino group, an N-isobutyl-N-methylamino group, an N-t-butyl-N-methylamino group, an N-methyl-N-n-pentylamino group, an N-n-hexyl-N-methylamino group, an N-ethyl-N-n-propylamino group, an N-ethyl-N-isopropylamino group, an N-n-butyl-N-ethylamino group, an N-ethyl-N-isobutylamino group, an N-t-butyl-N-ethylamino group, an N-ethyl-N-n-pentylamino group, or an N-ethyl-N-n-hexylamino group; a "di-$C_{3-18}$ alicyclic amino group", such as a dicyclopropylamino group, a dicyclobutylamino group, a dicyclopentylamino group, or a dicyclohexylamino group; a "di-$C_{6-18}$ arylamino group", such as a diphenylamino group or a phenylnaphthylamino group; an "N-$C_1$-$_{18}$ alkyl-N-$C_{3-18}$ cycloalkylamino group", such as an N-methylcyclopentaneamino group or an N-methylcyclohexylamino group; an "N-$C_1$-$_{18}$ alkyl-N-$C_{6-18}$ arylamino group", such as an N-methyl-2-phenylethylamino group or an N-ethyl-N-(4-methylphenyl)amino group; or the like.

The term "$C_1$-$_{18}$ hydrocarbylaminocarbonyl group", as used herein, refers to a group in which a carbonyl group (-C(=O)-) is bonded to the "$C_1$-$_{18}$ hydrocarbylamino group".

The "$C_1$-$_{18}$ hydrocarbylaminocarbonyl group" is, for example, but not limited to, a "$C_1$-$_{18}$ alkylaminocarbonyl group", such as a methylaminocarbonyl group, an ethylaminocarbonyl group, a n-propylaminocarbonyl group, an i-propylaminocarbonyl group, a n-butylaminocarbonyl group, a sec-butylaminocarbonyl group, a t-butylaminocarbonyl group, a n-pentylaminocarbonyl group, a 2-pentylaminocarbonyl group, a neopentylaminocarbonyl group, a 4-methyl-2-pentylaminocarbonyl group, a n-hexylaminocarbonyl group, or a 3-methyl-n-pentylaminocarbonyl group; a "$C_{3-18}$ alicyclic aminocarbonyl group", such as a cyclopropylaminocarbonyl group, a cyclobutylaminocarbonyl group, a cyclopentylaminocarbonyl group, a cyclohexylaminocarbonyl group, a 2-methylcyclopentylaminocarbonyl group, a 3-methylcyclopentylaminocarbonyl group, a 2-methylcyclohexylaminocarbonyl group, a 3-methylcyclohexylaminocarbonyl group, or a 4-methylcyclohexylaminocarbonyl group; or a "$C_{6-18}$ arylaminocarbonyl group", such as a phenylaminocarbonyl group, a 1-naphthylaminocarbonyl group, or a 2-naphthylaminocarbonyl group.

The term "di-$C_1$-$_{18}$ hydrocarbylaminocarbonyl group", as used herein, refers to a group in which a carbonyl group (-C(=O)-) is bonded to a "di-$C_1$-$_{18}$ hydrocarbylamino group".

The "di-$C_1$-$_{18}$ hydrocarbylaminocarbonyl group" is, for example, but not limited to, a "di-$C_1$-$_{18}$ alkylamino group", such as a dimethylaminocarbonyl group, a diethylaminocarbonyl group, a di-n-propylaminocarbonyl group, a diisopropylaminocarbonyl group, a di-n-butylaminocarbonyl group, a diisobutylaminocarbonyl group, a di-t-butylaminocarbonyl group, a di-n-pentylaminocarbonyl group, a di-n-hexylaminocarbonyl group, an N-ethyl-N-methylaminocarbonyl group, an N-methyl-N-n-propylaminocarbonyl group, an N-isopropyl-N-methylaminocarbonyl group, an N-n-butyl-N-methylaminocarbonyl group, an N-isobutyl-N-methylaminocarbonyl group, an N-t-butyl-N-methylaminocarbonyl group, an N-methyl-N-n-pentylaminocarbonyl group, an N-n-hexyl-N-methylaminocarbonyl group, an N-ethyl-N-n-propylaminocarbonyl group, an N-ethyl-N-isopropylaminocarbonyl group, an N-n-butyl-N-ethylaminocarbonyl group, an N-ethyl-N-isobutylaminocarbonyl group, an N-t-butyl-N-ethylaminocarbonyl group, an N-ethyl-N-n-pentylaminocarbonyl group,

or an N-ethyl-N-n-hexylaminocarbonyl group; a "di-$C_{3-18}$ alicyclic aminocarbonyl group", such as a dicyclopropylaminocarbonyl group, a dicyclobutylaminocarbonyl group, a dicyclopentylaminocarbonyl group, or a dicyclohexylaminocarbonyl group; a "di-$C_{6-18}$ arylaminocarbonyl group", such as a diphenylaminocarbonyl group or a phenylnaphthylaminocarbonyl group; or the like.

The term "$C_1$-$_{18}$ hydrocarbylcarbonylamino group", as used herein, refers to a group in which an amino group is bonded to the "$C_1$-$_{18}$ hydrocarbylcarbonyl group".

The "$C_1$-$_{18}$ hydrocarbylcarbonylamino group" is, for example, but not limited to, a "$C_1$-$_{18}$ alkyl carbonylamino group", such as a methyl carbonylamino group, an ethyl carbonylamino group, a n-propyl carbonylamino group, an i-propyl carbonylamino group, a n-butyl carbonylamino group, an i-butyl carbonylamino group, a sec-butyl carbonylamino group, a t-butyl carbonylamino group, a n-pentyl carbonylamino group, an i-pentyl carbonylamino group, or a n-hexyl carbonylamino group; a "$C_{3-18}$ alicyclic carbonylamino group", such as a cyclopropyl carbonylamino group, a cyclobutyl carbonylamino group, a cyclopentyl carbonylamino group, or a cyclohexyl carbonylamino group; a "$C_{6-18}$ aryl carbonylamino group", such as a phenyl carbonylamino group, a naphthyl carbonylamino group, an acenaphthyl carbonylamino group, a phenanthrenyl carbonylamino group, or an anthracenyl carbonylamino group; or the like.

The term "$C_1$-$_{18}$ hydrocarbylaminocarbonyloxy group", as used herein, refers to a group in which an oxygen atom (-O-) is bonded to the "$C_1$-$_{18}$ hydrocarbylaminocarbonyl group".

The "$C_1$-$_{18}$ hydrocarbylaminocarbonyloxy group" is, for example, but not limited to, a "$C_1$-$_{18}$ alkylaminocarbonyloxy group", such as a methylaminocarbonyloxy group, an ethylaminocarbonyloxy group, or a n-propylaminocarbonyloxy group; a "$C_{3-18}$ alicyclic aminocarbonyloxy group", such as a cyclopropylaminocarbonyloxy group or a cyclohexylaminocarbonyloxy group; a "$C_{6-18}$ arylaminocarbonyloxy group", such as a phenylaminocarbonyloxy group or a 1-naphthylaminocarbonyloxy group; or the like.

The term "di-$C_1$-$_{18}$ hydrocarbylaminocarbonyloxy group", as used herein, refers to a group in which an oxygen atom (-O-) is bonded to the "di-$C_1$-$_{18}$ hydrocarbylaminocarbonyl group".

The "di-$C_1$-$_{18}$ hydrocarbylaminocarbonyloxy group" is, for example, but not limited to, a "di-$C_1$-$_{18}$ alkylaminocarbonyloxy group", such as a dimethylaminocarbonyloxy group, a diethylaminocarbonyloxy group, or a di-n-propylaminocarbonyloxy group; or the like.

The term "$C_1$-$_{18}$ hydrocarbylaminocarbonylamino group", as used herein, refers to a group in which the "$C_1$-$_{18}$ hydrocarbylaminocarbonyl group" is bonded to an amino group.

The "$C_1$-$_{18}$ hydrocarbylaminocarbonylamino group" is, for example, but not limited to, a "$C_1$-$_{18}$ alkylaminocarbonylamino group", such as a methylaminocarbonylamino group, an ethylaminocarbonyloxy group, or a n-propylaminocarbonylamino group; a "$C_{3-18}$ alicyclic aminocarbonylamino group", such as a cyclopropylaminocarbonylamino group or a cyclohexylaminocarbonylamino group; a "$C_{6-18}$ arylaminocarbonylamino group", such as a phenylaminocarbonylamino group or a 1-naphthylaminocarbonylamino group; or the like.

The term "di-$C_1$-$_{18}$ hydrocarbylaminocarbonylamino group", as used herein, refers to a group in which a "di-$C_1$-$_{18}$ hydrocarbylaminocarbonyl group" is bonded to an amino group.

The "di-$C_1$-$_{18}$ hydrocarbylaminocarbonylamino group" is, for example, but not limited to, a "di-$C_1$-$_{18}$ alkylaminocarbonylamino group", such as a dimethylaminocarbonylamino group, a diethylaminocarbonylamino group, or a di-n-propylaminocarbonylamino group; or the like.

The term "$C_1$-$_{18}$ hydrocarbyloxycarbonylamino group", as used herein, refers to a group in which the "$C_1$-$_{18}$ hydrocarbyloxycarbonyl group" is bonded to an amino group.

The "$C_1$-$_{18}$ hydrocarbyloxycarbonylamino group" is, for example, but not limited to, a "$C_1$-$_{18}$ alkoxycarbonylamino group", such as a methoxycarbonylamino group, an ethoxycarbonylamino group, a n-propoxycarbonylamino group, an i-propoxycarbonylamino group, a n-butoxycarbonylamino group, or a t-butoxycarbonylamino group; a "$C_{3-18}$ alicyclic oxycarbonylamino group", such as a cyclopropyloxycarbonylamino group or a cyclohexyloxycarbonylamino group; a "$C_{6-18}$ aryloxycarbonylamino group", such as a phenyloxycarbonylamino group or a 1-naphthyloxycarbonylamino group; or the like.

The term "$C_1$-$_{18}$ hydrocarbylthio group", as used herein, refers to a group in which a sulfur atom (-S-) is bonded to the "$C_1$-$_{18}$ hydrocarbyl group".

The "$C_1$-$_{18}$ hydrocarbylthio group" is, for example, but not limited to, a "$C_1$-$_{18}$ alkylthio group", such as a methylthio group, an ethylthio group, a n-propylthio group, an i-propylthio group, a n-butylthio group, an i-butylthio group, a t-butylthio group, a n-pentylthio group, or a n-hexylthio group; a "$C_{3-18}$ alicyclic thio group", such as a cyclopropylthio group, a cyclobutylthio group, a cyclopentylthio group, a cyclohexylthio group, a 2-methylcyclopentylthio group, a 3-methylcyclopentylthio group, a 2-methylcyclohexylthio group, a 3-methylcyclohexylthio group, or a 4-methylcyclohexylthio group; a "$C_{6-18}$ arylthio group", such as a phenylthio group, a 1-naphthylthio group, a 2-naphthylthio group, an acenaphthylthio group, a phenanthrenylthio group, or an anthracenylthio group; or the like.

The term "$C_1$-$_{18}$ hydrocarbylsulfinyl group", as used herein, refers to a group in which a sulfinyl group (-S(=O)-) is bonded to the "$C_1$-$_{18}$ hydrocarbyl group".

The "$C_1$-$_{18}$ hydrocarbylsulfinyl group" is, for example, but not limited to, a "$C_1$-$_{18}$ alkylsulfinyl group", such as a

methylsulfinyl group, an ethylsulfinyl group, a n-propylsulfinyl group, an i-propylsulfinyl group, a n-butylsulfinyl group, a t-butylsulfinyl group, a pentylsulfinyl group, or a hexylsulfinyl group; a "$C_{3-18}$ alicyclic sulfinyl group", such as a cyclopropylsulfinyl group, a cyclobutylsulfinyl group, a cyclopentylsulfinyl group, a cyclohexylsulfinyl group, a 2-methylcyclopentylsulfinyl group, a 3-methylcyclopentylsulfinyl group, a 2-methylcyclohexylsulfinyl group, a 3-methylcyclohexylsulfinyl group, or a 4-methylcyclohexylsulfinyl group; a "$C_{6-18}$ arylsulfinyl group", such as a phenylsulfinyl group, a naphthylsulfinyl group, an acenaphthylsulfinyl group, a phenanthrenylsulfinyl group, or an anthracenylsulfinyl group; or the like.

The term "$C_1$-$_{18}$ hydrocarbylsulfonyl group", as used herein, refers to a group in which a sulfonyl group ($-SO_2-$) is bonded to the "$C_1$-$_{18}$ hydrocarbyl group".

The "$C_1$-$_{18}$ hydrocarbylsulfonyl group" is, for example, but not limited to, a "$C_1$-$_{18}$ alkylsulfonyl group", such as a methylsulfonyl group, an ethylsulfonyl group, a n-propylsulfonyl group, an i-propylsulfonyl group, a n-butylsulfonyl group, a t-butylsulfonyl group, or a pentylsulfonyl group; a "$C_{3-18}$ alicyclic sulfonyl group", such as a cyclopropylsulfonyl group, a cyclobutylsulfonyl group, a cyclopentylsulfonyl group, a cyclohexylsulfonyl group, a 2-methylcyclopentylsulfonyl group, a 3-methylcyclopentylsulfonyl group, a 2-methylcyclohexylsulfonyl group, a 3-methylcyclohexylsulfonyl group, or a 4-methylcyclohexyl group; a "$C_{6-18}$ arylsulfonyl group", such as a phenylsulfonyl group, a naphthylsulfonyl group, an acenaphthylsulfonyl group, a phenanthrenylsulfonyl group, or an anthracenylsulfonyl group; or the like.

The term "acid-dissociable group", as used herein, refers to a group that substitutes a hydrogen atom of a carboxy group or a hydroxy group (including a phenolic hydroxy group or the like) and is dissociated by the action of an acid.

The term "acid-dissociable group" is, for example, but not limited to, a t-butyl group, a t-amyl group, a 1,1-dimethylpropyl group, a 1-methyl-1-cyclopentyl group, a 1-ethyl-1-cyclopentyl group, a 1-methyl-1-cyclohexyl group, a 1-ethyl-1-cyclohexyl group, a 2-methyl-2-adamantyl group, a 2-ethyl-2-adamantyl group, a 1-(1-methoxy-2-methylpropan-2-yl)cyclopentyl group, a 1-(1-ethoxy-2-methylpropan-2-yl)cyclopentyl group, or the like.

The term "a hydroxy group or a carboxy group having a protective group", as used herein, refers to a hydroxy group or carboxy group in which the hydroxy group (including a phenolic hydroxy group) or the carboxy group is protected by an ether protective group, a silyl ether protective group, an acyl protective group, an aminocarbonyl protective group, or the like.

The ether protective group is, for example, but not limited to, a methyl group, a benzyl group, a p-methoxybenzyl group, a t-butyl group, a triphenylmethyl group, a p-methoxyphenyldiphenylmethyl group, di(p-methoxyphenyl)phenylmethyl group, or the like.

The silyl ether protective group is, for example, but not limited to, a t-butyldimethylsilyl group (TBS), a triisopropylsilyl group (TIPS), a trimethylsilyl group (TMS), a triethylsilyl group (TES), a t-butyldiphenylsilyl group (TBDPS), or the like.

The acyl protective group is, for example, but not limited to, an acetyl group, a pivaloyl group, a benzoyl group, or the like.

The aminocarbonyl protective group is, for example, but not limited to, a dimethylaminocarbonyl group, a diethylaminocarbonyl group, a diisopropylaminocarbonyl group, an N-phenyl-N-methyl-aminocarbonyl group, or the like.

The phrase "optionally substituted", as used herein, is not particularly limited, provided that it is chemically acceptable and has the advantages of the present invention.

The "substituent" is, for example, (1) a halogen atom, (2) a hydroxy group, (3) a thiol group, (4) a nitro group, (5) a cyano group, (6) a carboxy group, (7) an amino group, (8) a sulfo group, (9) a group in which a hydrogen atom of a carboxy group or a hydroxy group is substituted by an acid-dissociable group, (10) a hydroxy group or a carboxy group having a protective group, or (11) a $C_{1-8}$ hydrocarbyl group, a $C_{1-8}$ hydrocarbyloxy group, a $C_{1-8}$ hydrocarbylcarbonyl group, a $C_{1-8}$ hydrocarbylcarbonyloxy group, a $C_{1-8}$ hydrocarbyloxycarbonyl group, a $C_{1-8}$ hydrocarbyloxycarbonyloxy group, a $C_{1-8}$ hydrocarbylamino group, a di-$C_{1-8}$ hydrocarbylamino group, a $C_{1-8}$ hydrocarbylaminocarbonyl group, a di-$C_{1-8}$ hydrocarbylaminocarbonyl group, a $C_{1-8}$ hydrocarbylcarbonylamino group, a $C_{1-8}$ hydrocarbylaminocarbonyloxy group, a di-$C_{1-8}$ hydrocarbylaminocarbonyloxy group, a $C_{1-8}$ hydrocarbylaminocarbonylamino group, a di-$C_{1-8}$ hydrocarbylaminocarbonylamino group, a $C_{1-8}$ hydrocarbyloxycarbonylamino group, a $C_{1-8}$ hydrocarbylthio group, a $C_{1-8}$ hydrocarbylsulfinyl group, a $C_{1-8}$ hydrocarbylsulfonyl group, in which at least part of their hydrogen atoms may be substituted by (1) to (10) and a divalent carbon atom at any position except the end(s) of the substituent may be replaced by -O-, -C(=O)-, -C(=O)O-, -OCO-, -CONH-, -NHCO-, -NH(C=O)O-, -S-, or $-SO_2-$(provided that adjacent divalent carbon atoms are not replaced at the same time), or the like.

[1-1. Polyacid Salt]

The resist material according to the present embodiment contains a polyacid salt. The polyacid salt can be a known and commonly used polyacid salt and is not particularly limited. The polyacid salt (also referred to as a polyoxometalate) can adjust the absorbency for an exposure light source and the like by the combination of an anion moiety and a cation moiety of the polyacid salt.

The polyacid is an anionic metal oxide cluster represented by the general formula $[M_xO_y]^{n-}$ (wherein x, y, and n all

denote natural numbers). The metal atom M constituting the polyacid is referred to as a polyatom and is, for example, Mo (hexavalent or pentavalent), W (hexavalent or pentavalent), V (pentavalent), Nb (pentavalent), Ta (pentavalent), or the like. The polyacid can be broadly divided into an isopolyacid composed of the polyatom M and an oxoacid, and a heteropolyacid ($[X_wM_xO_y]^{n-}$ (wherein w, x, y, and n all denote natural numbers)) containing a different type of atom X (for example, $P^{5+}$, $Si^{4+}$, $Ge^{4+}$, $B^{3+}$, or the like as a heteroatom X) in addition to the polyatom M and oxygen.

The method for synthesizing the polyacid salt as the component (B) is not particularly limited and can be a known and commonly used method. The method for synthesizing the polyacid salt is, for example, a salt exchange method, an ion exchange method, or the like.

The polyacid salt is composed of an anion moiety of an isopolyacid or a heteropolyacid and a cation moiety serving as a counter cation therefor. The anion moiety and the cation moiety of the polyacid salt will be separately described below.

[1-1-1. Anion Moiety of Polyacid Salt]

The anion moiety of the polyacid salt is composed of an isopolyacid anion or a heteropolyacid anion.

The isopolyacid anion is, for example, an isopolyoxomolybdate anion, an isopolyoxotungstate anion, an isopolyoxovanadate anion, an isopolyoxoniobate anion, an isopolyoxotantalate anion, or the like.

The isopolyoxomolybdate anion is, for example, $[MoO_4]^{2-}$, $[Mo_7O_{24}]^{6-}$, $[Mo_8O_{26}]^{4-}$, or the like. The isopolyoxotungstate anion is, for example, $[W_4O_{13}]^{2-}$, $[W_5O_{16}]^{2-}$, $[W_6O_{19}]^{2-}$, $[W_7O_{22}]^{2-}$, $[W_7O_{24}]^{6-}$, $[H_zW_{12}O_{40}]^{-(8-z)}$ (wherein z denotes an integer in the range of 1 to 4), $[W_{10}O_{32}]^{4-}$, $[H_4W_{11}O_{38}]^{6-}$, $[H_7W_{11}O_{40}]^{7-}$, $[HW_5O_{19}]^{7-}$, $[H_3W_{11}O_{22}]^{5-}$, or the like. The isopolyoxovanadate anion is, for example, $[V_4O_{12}]^{4-}$, $[V_{10}O_{28}]^{6-}$, or the like, the isopolyoxoniobate anion is, for example, $[Nb_6O_{19}]^{8-}$, $[Nb_{10}O_{28}]^{6-}$, or the like, and the isopolyoxotantalate anion is, for example, $[Ta_6O_{19}]^{8-}$, $[Ta_8O_{21}]^{2-}$, or the like.

The isopolyoxomolybdate anion, the isopolyoxotungstate anion, the isopolyoxovanadate anion, the isopolyoxoniobate anion, and the isopolyoxotantalate anion include various isomers and the like.

The heteropolyacid anion is, for example, a heteropolyoxomolybdate anion, a heteropolyoxotungstate anion, a heteropolyoxovanadate anion, a heteropolyoxoniobate anion, a heteropolyoxotantalate anion, or the like.

The heteropolyoxomolybdate anion is, for example, a phosphomolybdate anion, a silicomolybdate anion, a boromolybdate anion, a phosphotungstomolybdate anion, a cobalt molybdate anion, an arsenic molybdate anion, a germanium molybdate anion, or the like. The heteropolyoxotungstate anion is, for example, a phosphotungstate anion, a silicotungstate anion, a borotungstate anion, a cobalt tungstate anion, an arsenic tungstate anion, a germanium tungstate anion, or the like. The heteropolyoxovanadate anion is, for example, a phosphomolybdovanadate anion, a phosphomolybdotungstomolybdate anion, a boromolybdovanadate anion, a boromolybdotungstovanadate anion, or the like.

The heteropolyoxomolybdate anion, the heteropolyoxotungstate anion, the heteropolyoxovanadate anion, and the like include a Keggin type, a Dawson type, an Anderson type, and deficient species and isomers thereof.

[1-1-2. Cation Moiety of Polyacid Salt]

The type of the salt of the polyacid salt (isopolyoxometalate or heteropolyoxometalate) is not particularly limited and may be a salt with a proton, an onium cation (for example, an organic onium cation, an organic sulfonium cation, an organic iodonium cation, an organic quaternary ammonium cation, an organic phosphonium cation, or the like), an alkali metal ion, or the like. From the perspective of improving actinic ray sensitivity or radiation sensitivity and changing the solvent solubilities of an exposed portion and an unexposed portion, the type of the salt of the polyacid salt is preferably a salt with an onium cation; more preferably, the onium cation has at least one optionally substituted unsaturated bond; and among them, a salt with an organic sulfonium cation, an organic iodonium cation, or an organic quaternary ammonium cation is more preferred. Furthermore, the unsaturated bond is, for example, a carbon-carbon double bond or a carbon-carbon triple bond, and from the same perspective as described above, a carbon-carbon double bond is more preferred, and a benzene ring is still more preferred.

[1-1-2-1. Organic Sulfonium Cation]

The organic sulfonium cation is not particularly limited and may be a known and commonly used organic sulfonium cation. The organic sulfonium cation is, for example, an organic sulfonium cation represented by the formula (I).

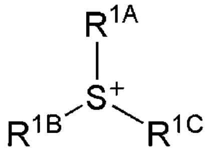
(I)

In the formula (I), $R^{1A}$, $R^{1B}$, and $R^{1C}$ each independently denote a $C_{1-18}$ hydrocarbyl group or a 3- to 18-membered non-aromatic heterocyclic group,

a divalent carbon atom at any position except the end(s) of $R^{1A}$, $R^{1B}$, and $R^{1C}$ may be replaced by -O-, -C(=O)-, -C(=O)O-, -OCO-, -CONH-, -NHCO-, -NH(C=O)O-, -S-, or $-SO_2-$ (provided that adjacent divalent carbon atoms are not replaced at the same time),

a hydrogen atom in $R^{1A}$, $R^{1B}$, and $R^{1C}$ is, for example, (a) a halogen atom, (b) a haloalkyl group, (c) a hydroxy group, (d) a thiol group, (e) a nitro group, (f) a cyano group, (g) a carboxy group, (h) an amino group, (i) a sulfo group, (j) a group in which a hydrogen atom of a carboxy group or a hydroxy group is substituted by an acid-dissociable group, (k) a hydroxy group or a carboxy group having a protective group, or (l) a $C_{1-18}$ hydrocarbyl group, a $C_{1-18}$ hydrocarbyloxy group, a $C_{1-18}$ hydrocarbylcarbonyl group, a $C_{1-18}$ hydrocarbylcarbonyloxy group, a $C_{1-18}$ hydrocarbyloxycarbonyl group, a $C_{1-18}$ hydrocarbyloxycarbonyloxy group, or a $C_{1-18}$ hydrocarbylthio group, in which at least part of a hydrogen atom may be substituted by (a) to (k), and a divalent carbon atom at any position except the ends of these substituents may be replaced by -O-, -C(=O)-, - C(=O)O-, -OCO-, -CONH-, -NHCO-, -NH(C=O)O-, -S-, or $-SO_2-$ (provided that adjacent divalent carbon atoms are not replaced at the same time); and

any two of $R^{1A}$, $R^{1B}$, and $R^{1C}$ may be linked to each other directly by a single bond or via a divalent linking group -O-, -S-, -C(=O)-, -S(=O)-, $-S(=O)_2-$, -C(=O)O-, or a $C_{1-3}$ alkylene group to form a ring together with a sulfur atom in the (I).

From the perspective of patterning characteristics, at least one of $R^{1A}$, $R^{1B}$, and $R^{1C}$ in the formula (I) is preferably a $C_{2-18}$ aryl group that may have the substituent described above, more preferably a phenyl group that may have the substituent described above.

When at least one of $R^{1A}$, $R^{1B}$, and $R^{1C}$ in the formula (I) is an optionally substituted phenyl group, specific examples include the formula (I-1).

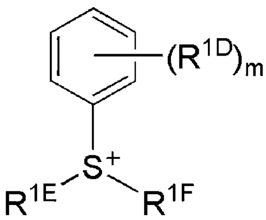
(I-1)

In the formula (I-1),

$R^{1D}$ preferably each independently denotes a halogen atom, a hydroxy group, a nitro group, a cyano group, a thiol group, an optionally substituted $C_{1-18}$ haloalkyl group, a $C_{1-18}$ hydrocarbyloxy group, a $C_{1-18}$ hydrocarbyloxycarbonyl group, a $C_{1-18}$ hydrocarbylcarbonyloxy group, or a $C_{1-18}$ hydrocarbylthio group,

more preferably a halogen atom, a nitro group, a cyano group, an optionally substituted $C_{1-4}$ haloalkyl group, a $C_{1-12}$ hydrocarbyloxy group, a $C_{1-12}$ hydrocarbyloxycarbonyl group, a $C_{1-12}$ hydrocarbylcarbonyloxy group, or a $C_{1-12}$ hydrocarbylthio group,

still more preferably a halogen atom or an optionally substituted $C_{1-4}$ haloalkyl group;

$R^{1E}$ and $R^{1F}$ may each independently have the same definition as $R^{1A}$ to $R^{1C}$ described above, and $R^{1E}$ and $R^{1F}$ may be linked to each other directly by a single bond or via a divalent linking group -O-, -S-, -C(=O)-, -S(=O)-, $-S(=O)_2-$, -C(=O)O-, or a $C_{1-3}$ alkylene group to form a ring together with a sulfur atom in the formula (I-1); and

m denotes an integer in the range of 0 to 5.

Furthermore, in the formula (1-1), at least one of $R^{1D}$, $R^{1E}$, and $R^{1F}$ preferably contains a halogen atom.

$R^{1A}$, $R^{1B}$, and $R^{1C}$ in the formula (I) preferably each independently denote an optionally substituted $C_{2-18}$ aryl group. A substituent for the $C_{2-18}$ aryl group is preferably a halogen atom, a haloalkyl group, a hydroxy group, a nitro group, a cyano group, or an optionally substituted $C_{1-12}$ hydrocarbylthio group, more preferably a halogen atom, a $C_{1-4}$ haloalkyl group, or a nitro group. And at least one of $R^{1A}$, $R^{1B}$, and $R^{1C}$ in the formula (I) preferably contains a halogen atom.

Furthermore, at least one of $R^{1A}$, $R^{1B}$, and $R^{1C}$ in the formula (I) contains a halogen atom.

Specific examples of the organic sulfonium cation include those corresponding to formula (I) but not to formula (I-1), such as a dibutyl(pentyl)sulfonium cation, a triethylsulfonium cation, (2-carboxyethyl)dimethylsulfonium cation, a trimethylsulfonium cation, a dimethylphenacylsulfonium cation, a 1-(4-hydroxynaphthalen-1-yl)hexahydrothiopyrylium cation.

Additionally, specific examples corresponding to formula (I-1) include a dimethylphenylsulfonium cation, a triphenylsulfonium cation, a tris(4-methylphenyl)sulfonium cation, a 4-methoxyphenyldiphenylsulfonium cation, a 4-iodophenyldiphenylsulfonium cation, a tris(4-fluorophenyl)sulfonium cation, a 1-phenylhexahydrothiopyrylium cation, an (ethane-1,2-diylbisoxy)bis(4,1-phenylene)bis(diphenylsulfonium) dication, a (thiodi-4,1-phenylene)bis(diphenylsulfonium) dication, a di(naphthalen-1-yl)(phenyl)sulfonium cation, a phenyl bis(2-(trifluoromethyl)phenyl)sulfonium cation, a mesityl bis(2-(trifluoromethyl)phenyl)sulfonium cation, a bis(3,5-difluorophenyl)(phenyl)sulfonium cation, a tris(3,5-difluorophenyl)sulfonium cation, a (4-(dodecanoyloxy-3,5-dimethylphenyl))diphenylsulfonium cation, a diphenyl(3-(trifluoromethoxy)phenyl)sulfonium cation, a (4-(1-adamantylcarbonyloxy)phenyl)diphenylsulfonium cation, a (4-phenylthiophenyl)diphenylsulfonium cation, a 5-phenyl-5H-thianthren-5-ium cation, a 5-(2,5-dimethylphenyl)thianthren-5-ium cation, a 5-phenyl-5H-dibenzo[b,d]thiophen-5-ium cation a 5-(3-(trifluoromethyl)phenyl)-5H-dibenzo[b,d]thiophen-5-ium cation, a 1-(4-(t-butyl)phenyl)-1H-benzo[b]thiophen-1-ium cation, a methyldiphenylsulfonium cation, a (2-bromoethyl)diphenylsulfonium cation, a (3-chloropropyl)diphenylsulfonium cation, a benzyl(4-hydroxyphenyl)methylsulfonium cation, a (4-hydroxyphenyl)methyl(2-methylbenzyl)sulfonium cation, a 4-hydroxyphenyldimethylsulfonium cation, a diphenyl(methyl)sulfonium cation, a diphenyl(4-(phenylthio)phenyl)sulfonium cation, a (2-bromoethyl)diphenylsulfonium cation, a dimesityl(trifluoromethyl)sulfonium cation, and a tri-p-tolylsulfonium cation.

[1-1-2-2. Organic Iodonium Cation]

The organic iodonium cation is not particularly limited and may be a known and commonly used organic iodonium cation. The organic iodonium cation is, for example, an organic iodonium cation represented by the formula (II).

$$R^{2A}—\overset{+}{I}—R^{2B} \quad (II)$$

In the formula (II), $R^{2A}$ and $R^{2B}$ each independently denote a $C_{1-18}$ hydrocarbyl group or a 3- to 18-membered non-aromatic heterocyclic group,

a divalent carbon atom at any position except the end(s) of $R^{2A}$ and $R^{2B}$ may be replaced by -O-, -C(=O)-, -C(=O)O-, -OCO-, -CONH-, -NHCO-, -NH(C=O)O-, -S-, or - $SO_2$- (provided that adjacent divalent carbon atoms are not replaced at the same time);

a hydrogen atom in $R^{2A}$ and $R^{2B}$ is, for example, (a) a halogen atom, (b) a haloalkyl group, (c) a hydroxy group, (d) a thiol group, (e) a nitro group, (f) a cyano group, (g) a carboxy group, (h) an amino group, (i) a sulfo group, (j) a group in which a hydrogen atom of a carboxy group or a hydroxy group is substituted by an acid-dissociable group, (k) a hydroxy group or a carboxy group having a protective group, or (l) a $C_{1-18}$ hydrocarbyl group, a $C_{1-18}$ hydrocarbyloxy group, a $C_{1-18}$ hydrocarbylcarbonyl group, a $C_{1-18}$ hydrocarbylcarbonyloxy group, a $C_{1-18}$ hydrocarbyloxycarbonyl group, or a $C_{1-18}$ hydrocarbyloxycarbonyloxy group, in which at least part of a hydrogen atom may be substituted by (a) to (k), and a divalent carbon atom at any position except the ends of these substituents may be replaced by -O-, -C(=O)-, -C(=O)O-, -OCO-, -CONH-, - NHCO-, -NH(C=O)O-, -S-, or -$SO_2$- (provided that adjacent divalent carbon atoms are not replaced at the same time); and

furthermore, $R^{2A}$ and $R^{2B}$ may be linked to each other directly by a single bond or via a divalent linking group -O-, -S-, -C(=O)-, -S(=O)-, -S(=O)$_2$-, -C(=O)O-, or a $C_{1-3}$ alkylene group to form a ring together with the iodine atom in the formula (II).

$R^{2A}$ and $R^{2B}$ in the formula (II) preferably each independently denote an optionally substituted $C_{2-18}$ aryl group. A substituent for the $C_{2-18}$ aryl group is preferably a halogen atom, a haloalkyl group, a hydroxy group, a nitro group, a cyano group, a thiol group, an optionally substituted $C_{1-12}$ hydrocarbyl group, $C_{1-12}$ hydrocarbyloxy group, $C_{1-12}$ hydrocarbylcarbonyl group, $C_{1-12}$ hydrocarbylcarbonyloxy group, $C_{1-12}$ hydrocarbyloxycarbonyl group, or $C_{1-12}$ hydrocarbyloxycarbonyloxy group, preferably a halogen atom, a $C_{1-4}$ haloalkyl group, a nitro group, a $C_{1-8}$ hydrocarbyl group, or a $C_{1-8}$ hydrocarbyloxy group.

Specific examples of the organic iodonium cations include an ethynyl(phenyl)iodonium cation, a bis(pyridine)iodonium cation, a bis(2,4,6-trimethylpyridine)iodonium cation, a diphenyliodonium cation, a bis(4-(t-butyl)phenyl)iodonium cation, a (2-carboxyphenyl)(phenyl)iodonium cation, a (4-nitrophenyl)(phenyl)iodonium cation, a (3-(trifluoromethyl)phenyl)(2,4,6-trimethylphenyl)iodonium cation, a bis(4-fluorophenyl)iodonium cation, a (4-(bromomethyl)phenyl)(2,4,6-trimethoxyphenyl)iodonium cation, a 4-biphenylyl(2,4,6-trimethoxyphenyl)iodonium cation, a bis(2,4,6-trimethylphenyl) iodonium cation, a 4-isopropyl-4'-methyldiphenyliodonium cation, a (4-(trifluoromethyl)phenyl)(2,4,6-trimethylphenyl) iodonium cation, a ((4-trifluoromethyl)phenyl)(2,4,6-trimethoxyphenyl)iodonium cation, a (5-fluoro-2-nitrophenyl)(2,4,6-trimethoxyphenyl)iodonium cation, a (3-bromophenyl)(mesityl)iodonium cation, a bis(4-bromophenyl)iodonium cation, a (3,5-dichlorophenyl)(2,4,6-trimethoxyphenyl)iodonium cation, a (4-methylphenyl)(2,4,6-trimethylphenyl)iodonium cation, a (3-methylphenyl)(2,4,6-trimethylphenyl)iodonium cation, a (2-methylphenyl)(2,4,6-trimethylphenyl)iodonium cation, a phenyl(2,4,6-trimethoxyphenyl)iodonium cation, and the like.

[1-1-2-3. Organic Quaternary Ammonium Cation]

The organic quaternary ammonium cation is not particularly limited and may be a known and commonly used organic quaternary ammonium cation. The organic quaternary ammonium cation is, for example, an organic quaternary ammonium cation represented by the formula (III).

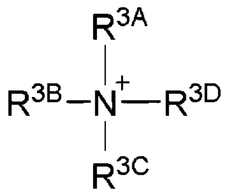

(III)

In the formula (III), $R^{3A}$, $R^{3B}$, $R^{3C}$, and $R^{3D}$ each independently denote a $C_{1-18}$ hydrocarbyl group or a 3- to 18-membered non-aromatic heterocyclic group,

a divalent carbon atom at any position except the end(s) of $R^{3A}$, $R^{3B}$, $R^{3C}$, and $R^{3D}$ may be replaced by -O-, -C(=O)-, -C(=O)O-, -OCO-, -CONH-, -NHCO-, -NH(C=O)O-, - S-, or $-SO_2-$ (provided that adjacent divalent carbon atoms are not replaced at the same time);
a hydrogen atom in $R^{3A}$, $R^{3B}$, $R^{3C}$, and $R^{3D}$ is, for example, (a) a halogen atom, (b) a haloalkyl group, (c) a hydroxy group, (d) a thiol group, (e) a nitro group, (f) a cyano group, (g) a carboxy group, (h) an amino group, (i) a sulfo group, (j) a group in which a hydrogen atom of a carboxy group or a hydroxy group is substituted by an acid-dissociable group, (k) a hydroxy group or a carboxy group having a protective group, or (l) a $C_{1-18}$ hydrocarbyl group, a $C_{1-18}$ hydrocarbyloxy group, a $C_{1-18}$ hydrocarbylcarbonyl group, a $C_{1-18}$ hydrocarbylcarbonyloxy group, a $C_{1-18}$ hydrocarbyloxycarbonyl group, a $C_{1-18}$ hydrocarbyloxycarbonyloxy group, or a $C_{1-18}$ hydrocarbylthio group, in which at least part of a hydrogen atom may be substituted by (a) to (k), and a divalent carbon atom at any position except the ends of these substituents may be replaced by -O-, -C(=O)-, - C(=O)O-, -OCO-, -CONH-, -NHCO-, -NH(C=O)O-, -S-, or $-SO_2-$ (provided that adjacent divalent carbon atoms are not replaced at the same time); and
furthermore, any two of $R^{3A}$, $R^{3B}$, $R^{3C}$, and $R^{3D}$ may be linked to each other directly by a single bond or via a divalent linking group -O-, -S-, -C(=O)-, -S(=O)-, $-S(=O)_2-$, - C(=O)O-, or a $C_{1-3}$ alkylene group to form a ring together with the nitrogen atom in the formula (III).

$R^{3A}$, $R^{3B}$, $R^{3C}$, and $R^{3D}$ in the formula (III) preferably each independently denote an optionally substituted $C_{1-18}$ hydrocarbyl group, more preferably a $C_{1-12}$ alkyl group, a $C_{1-12}$ alkenyl group, a $C_{1-12}$ alkynyl group, or a $C_{1-12}$ alicyclic group.

Specific examples of the organic quaternary ammonium cation include a tetramethylammonium cation, a tetraethylammonium cation, a tetrapropylammonium cation, a tetrabutylammonium cation, a tetraheptylammonium cation, a trimethylethylammonium cation, a dimethyldiethylammonium cation, a dimethylethylpropylammonium cation, a methylethylpropylbutylammonium cation, a trimethylphenylammonium cation, a triethylhexylammonium cation, a triethylcyclohexylammonium cation, and a dodecyltrimethylammonium cation.

[1-2. Organic Solvent]

The resist material according to the present embodiment may further contain an organic solvent. The organic solvent is not particularly limited and may be a known and commonly used organic solvent. The organic solvent is preferably an organic solvent that can uniformly dissolve or disperse the polyacid salt at the time of preparation.

Examples of the organic solvent include a polar solvent, such as an alcohol solvent, an ether solvent, a ketone solvent, an amide solvent, an ester solvent, a nitrile solvent, or an aprotic polar solvent, and a nonpolar solvent, such as a

hydrocarbon solvent. These organic solvents may be used alone or in combination of two or more types thereof.

Specific examples of the polar solvent include an alcohol solvent, such as methanol, ethanol, isopropyl alcohol (IPA), 3-methoxybutanol, 3-methyl-3-methoxybutanol, 1-methoxy-2-propanol, 4-methyl-2-pentanol, ethylene glycol, diethylene glycol, propylene glycol, dipropylene glycol, or propylene glycol monomethyl ether (PGME);

an ether solvent, such as diethyl ether, dipropyl ether, dibutyl ether, diisoamyl ether, tetrahydrofuran, anisole, propylene glycol monoethyl ether, ethylene glycol monomethyl ether, or ethylene glycol monoethyl ether;
a ketone solvent, such as acetone, methyl ethyl ketone, cyclopentanone, cyclohexanone, methyl n-pentyl ketone, methyl isopentyl ketone, 2-heptanone, acetophenone, propylene carbonate, or furfural;
an amide solvent, such as N,N-dimethylformamide, N,N-diethylformamide, acetamide, N-methylpyrrolidone, 1-ethyl-2-pyrrolidone, or 1-butyl-2-pyrrolidone;
an ester solvent, such as methyl lactate, ethyl lactate (EL), methyl acetate, ethyl acetate, methyl pyruvate, ethyl pyruvate, methyl methoxypropionate, or propylene glycol monomethyl ether acetate (PGMEA);
a nitrile solvent, such as acetonitrile, propionitrile, or benzonitrile; and
an aprotic polar solvent, such as $\gamma$-butyrolactone, $\delta$-valerolactone, $\gamma$-lactam, $\delta$-lactam, dimethyl sulfoxide (DMSO), sulfolane, 1,3-dimethyl-2-imidazolidinone, or tetramethylurea; and
the nonpolar solvent may be a hydrocarbon solvent, such as n-pentane, n-hexane, toluene, or xylene;
or the like.

These organic solvents may be used alone or in combination of two or more types thereof.

The organic solvent to be contained in the resist material according to the present embodiment is preferably a polar solvent from the perspective of coatability, more preferably an amide solvent, an ester solvent, an alcohol solvent, or a ketone solvent from the perspective of solubility. The amide solvent is preferably at least one selected from the group consisting of N,N-dimethylformamide, N,N-diethylformamide, acetamide, and N-methylpyrrolidone. Furthermore, from the perspective of solubility, the ester solvent or the alcohol solvent preferably has an ester bond and/or a hydroxy group, and among those described above, at least one selected from the group consisting of propylene glycol monomethyl ether, methyl lactate, ethyl lactate, methyl acetate, ethyl acetate, methyl pyruvate, ethyl pyruvate, and propylene glycol monomethyl ether acetate is preferred.

In a case where the organic solvent includes both an amide solvent and an ester solvent, the blend ratio (mass ratio) of the amide solvent to the ester solvent preferably ranges from 1:99 to 40:60, more preferably 5:95 to 20:80.

Furthermore, in a case where the organic solvent includes any one or more of the ester solvent, the alcohol solvent, and the ketone solvent, the blend ratio (mass ratio) with respect to the organic solvent is preferably 50% or more by mass, more preferably 70% or more by mass, and may be 100% by mass.

The organic solvent content of the resist material is not particularly limited and can be appropriately determined according to the method for applying the resist material to a substrate or the like, the thickness of the film to be applied, and the like. The organic solvent content of the resist material is such that the solid concentration of the resist material preferably ranges from 0.01% to 20% by mass, more preferably 0.1% to 15% by mass, still more preferably 0.2% to 10% by mass.

[1-3. Others]

If desired, the resist material according to the present embodiment can appropriately contain, as a miscible additive agent, for example, an additional resin for improving the performance of a resist film, a dissolution inhibitor, a plasticizer, a stabilizer, a colorant, an antihalation agent, a dye, or the like.

The resist material according to the present embodiment preferably does not contain an epoxy resin. Furthermore, hydrogen peroxide is also preferably not contained.

[2. Pattern Forming Method]

The pattern forming method according to the present embodiment includes a step of applying a resist material to a substrate, a step of exposing a resist film formed by the application step to light, and a step of developing the exposed resist film.

[2-1. Application Step]

The pattern forming method according to the present embodiment includes the step of applying a resist material to a substrate.

<Substrate>

The substrate used in the present embodiment is not particularly limited and can be a known and commonly used substrate. The substrate is, for example, a substrate for an electronic component, a substrate on which a predetermined wiring pattern is formed, or the like

The material of the substrate is, for example, but not limited to, a silicon wafer, a substrate made of a metal, such as copper, chromium, iron, or aluminum, a substrate made of an inorganic substance, such as glass, titanium oxide, or silicon dioxide, or the like.

The substrate may have any size, shape, and the like, may have a smooth, curved, or rough surface, and may be a flaky substrate or the like.

The surface of the substrate may be subjected to a surface treatment as necessary. In the case of a substrate having a hydroxy group on a surface layer thereof, the surface of the substrate may be treated with a silane coupling agent capable of reacting with the hydroxy group to change the surface layer of the substrate from hydrophilic to hydrophobic, thereby enhancing the adhesion between the substrate and a film containing a metal compound. The silane coupling agent is, for example, hexamethyldisilazane (HMDS) or the like.

<Application Method>

The method for applying the resist material to a substrate is not particularly limited and can be a known and commonly used method. The application method includes a dry method, for example, a chemical vapor deposition (CVD) method, such as thermal CVD, plasma CVD, or photo-CVD; a physical vapor deposition (PVD) method, such as vacuum deposition, plasma-assisted vapor deposition, sputtering, or ion plating; or the like. A wet method, for example, a coating method, such as spin coating, bar coating, roll coating, flow coating, dip coating, spray coating, ink jet printing, or screen printing, can also be used.

From the perspective of forming a film with a uniform thickness or the like, the method for applying the resist material according to the present embodiment to a substrate is preferably a wet method, such as a spin coating method or screen printing, more preferably a spin coating method. After the coating film is formed, a backside rinse step, an edge bead removal step, or the like may be performed to remove an edge bead.

A resist film formed by applying the resist material to a substrate may be dried by any method, for example, using a heater (post-apply bake (PAB)), such as a hot plate, or a pressure reduction apparatus.

The baking conditions are not particularly limited and can be appropriately determined according to the type, application, and the like of the resist film. The baking temperature preferably ranges from 80°C to 300°C, more preferably 150°C to 250°C, still more preferably 170°C to 230°C. The baking time preferably ranges from 10 seconds to 300 seconds, more preferably 20 seconds to 180 seconds, still more preferably 30 seconds to 120 seconds.

The thickness of the resist film after drying is preferably, but not limited to, in the range of 0.5 to 100 nm, more preferably 1 to 75 nm, still more preferably 1 to 60 nm.

[2-2. Exposure Step]

The pattern forming method according to the present embodiment includes a step of exposing the resist film formed by the application step to light.

As an exposure apparatus in the exposure step of the resist film, for example, an ArF exposure apparatus, an electron-beam lithography system, an EUV exposure apparatus, or the like can be used. Furthermore, in the exposure step, exposure may be performed through a mask (mask pattern) on which a predetermined pattern is formed, or selective exposure may be performed by drawing or the like by direct irradiation with an electron beam without using a mask pattern.

The exposure wavelength is not particularly limited, and radiation, such as an ArF excimer laser (wavelength: 193 nm), a KrF excimer laser (248 nm), an $F_2$ excimer laser (wavelength: 157 nm), extreme ultraviolet (EUV), vacuum ultraviolet (VUV), an electron beam (EB), X-rays, soft X-rays, or the like may be used.

For an ArF excimer laser or a KrF excimer laser, the exposure level on the resist film preferably ranges from 1 to 200 mJ/cm$^2$, more preferably 20 to 60 mJ/cm$^2$. Furthermore, for extreme ultraviolet, the exposure level is, for example, 500 mJ/cm$^2$ or less, preferably 0.1 to 200 mJ/cm$^2$, more preferably 3 to 100 mJ/cm$^2$, still more preferably 5 to 50 mJ/cm$^2$.

For an electron beam, exposure at a dose in the range of 3 $\mu$C/cm$^2$ to 2 mC/cm$^2$ at 50 kV is preferred, and exposure at a dose in the range of 10 $\mu$C/cm$^2$ to 1.5 mC/cm$^2$ is more preferred.

After the resist film is exposed to light, a baking (post-exposure bake (PEB)) treatment may or may not be performed. The baking conditions are not particularly limited and can be appropriately determined according to the type, application, and the like of the resist film. The baking temperature preferably ranges from 80°C to 300°C, more preferably 150°C to 250°C, still more preferably 170°C to 230°C, using a heater, such as a hot plate. The baking time preferably ranges from 10 seconds to 300 seconds, more preferably 20 seconds to 180 seconds, still more preferably 30 seconds to

120 seconds.

[2-3. Development Step]

The pattern forming method according to the present embodiment includes the step of developing the exposed resist film. In the development step, the exposed resist film can be developed with a developer to form a pattern. A case where the exposed region remains as a pattern after development is a negative patterning process, and a case where the exposed region is removed after development is a positive patterning process. Whether a positive or negative pattern is formed can be appropriately selected depending on the resist material or the developer. Furthermore, the development may be followed by washing with a rinse liquid and drying, and in some cases, further followed by a baking treatment.

<Developer>

The developer used in the present embodiment is, for example, a developer containing at least one of a polar solvent, such as a ketone solvent, an ester solvent, an alcohol solvent, a nitrile solvent, an amide solvent, or an ether solvent, and an organic solvent, such as a hydrocarbon solvent.
Specific examples of the organic solvent include:

a ketone solvent, such as acetone, methyl ethyl ketone, cyclopentanone, cyclohexanone, methyl n-pentyl ketone, methyl isopentyl ketone, 2-heptanone, acetophenone, propylene carbonate, or furfural;
an ester solvent, such as methyl lactate, ethyl lactate (EL), methyl acetate, ethyl acetate, methyl pyruvate, ethyl pyruvate, methyl methoxypropionate, or propylene glycol monomethyl ether acetate (PGMEA);
an alcohol solvent, such as methanol, ethanol, isopropyl alcohol (IPA), 3-methoxybutanol, 3-methyl-3-methoxybutanol, 1-methoxy-2-propanol, 4-methyl-2-pentanol, ethylene glycol, diethylene glycol, propylene glycol, dipropylene glycol, or propylene glycol monomethyl ether (PGME);
a nitrile solvent, such as acetonitrile, propionitrile, or benzonitrile;
an amide solvent, such as N,N-dimethylformamide, N,N-diethylformamide, acetamide, N-methylpyrrolidone, 1-ethyl-2-pyrrolidone, or 1-butyl-2-pyrrolidone;
an ether solvent, such as diethyl ether, dipropyl ether, dibutyl ether, diisoamyl ether, tetrahydrofuran, anisole, propylene glycol monoethyl ether, ethylene glycol monomethyl ether, or ethylene glycol monoethyl ether; and
a hydrocarbon solvent, such as n-pentane, n-hexane, toluene, or xylene.

These may be used alone or in combination of two or more types thereof.
Among these, the organic solvent used in the developer is preferably a polar solvent, preferably contains an amide solvent, an alcohol solvent, or an ester solvent, more preferably contains an amide solvent or an ester solvent and an alcohol solvent.
The amide solvent is preferably at least one selected from the group consisting of N,N-dimethylformamide, N,N-diethylformamide, acetamide, and N-methylpyrrolidone.
Furthermore, the ester solvent is preferably one or more selected from the group consisting of methyl lactate, ethyl lactate (EL), methyl acetate, ethyl acetate, methyl pyruvate, ethyl pyruvate, methyl methoxypropionate, and propylene glycol monomethyl ether acetate.
The alcohol solvent is preferably at least one selected from the group consisting of ethanol, isopropyl alcohol (IPA), 3-methoxybutanol, 3-methyl-3-methoxybutanol, 1-methoxy-2-propanol, 4-methyl-2-pentanol, benzyl alcohol, and 4-methylbenzyl alcohol.
In a case where the developer contains both an amide solvent or an ester solvent and an alcohol solvent, the blend ratio (weight ratio) of the amide solvent or the ester solvent to the alcohol solvent preferably ranges from 5:95 to 95:5, more preferably 10:90 to 90: 10.
The method for developing the exposed resist film using the developer is not particularly limited and can be a known and commonly used method. The method of developing using the developer is, for example, a method of immersing the substrate having the exposed resist film in the developer for a certain period (dip method), a method of spraying the developer on the surface of the exposed resist film (spray method), a method of discharging the developer from a discharge nozzle at a constant speed toward the surface of the exposed resist film on the substrate rotating at a constant speed (dynamic dispense method), or the like.

<Rinse Liquid>

The development with the developer may be followed by a step of washing with a rinse liquid. The rinse liquid is not particularly limited and may be a known and commonly used rinse liquid. As the rinse liquid, among the organic

solvent(s) in the developer, a solvent that is less likely to dissolve the resist pattern can be appropriately selected and used.

The rinse liquid is, for example, but not limited to, at least one organic solvent selected from the group consisting of a hydrocarbon solvent, a ketone solvent, an ester solvent, an alcohol solvent, an amide solvent, and an ether solvent. Among these, the rinse liquid is preferably at least one organic solvent selected from the group consisting of a hydrocarbon solvent, a ketone solvent, an ester solvent, an alcohol solvent, and an amide solvent, more preferably at least one selected from the group consisting of an alcohol solvent and an ester solvent, still more preferably at least one alcohol solvent.

The alcohol solvent used in the rinse liquid is preferably a monohydric alcohol with 6 to 8 carbon atoms, and the monohydric alcohol may be linear, branched, or cyclic. Specific examples of the monohydric alcohol include ethanol, isopropyl alcohol(IPA), butanol, 1-hexanol, 1-heptanol, 1-octanol, 2-hexanol, 2-heptanol, 2-octanol, 3-hexanol, 3-heptanol, 3-octanol, 4-octanol, and benzyl alcohol.

These organic solvents may be used alone or in combination of two or more types thereof.

In addition to the organic solvents described above, the rinse liquid may further include an organic solvent other than the organic solvents described above or water. In a case where the rinse liquid contains water, the water content is preferably 30% or less by mass, more preferably 10% or less by mass, still more preferably 5% or less by mass, particularly preferably 3% or less by mass, relative to the total amount of the rinse liquid.

The method for washing the resist pattern with the rinse liquid is not particularly limited and can be a known and commonly used method. The method of washing using the rinse liquid is, for example, a method of immersing the resist pattern in the rinse liquid for a certain period (dip method), a method of spraying the rinse liquid onto the surface of the resist pattern (spray method), and a method of discharging the rinse liquid from a discharge nozzle at a constant speed toward the surface of the resist pattern rotating at a constant speed (dynamic dispense method), or the like.

<Development by Dry Etching>

After the resist film is exposed to light or after the resist film is exposed to light and is then subjected to a baking (post-exposure bake (PEB)) treatment, the resist film may be developed by dry etching to form a pattern. Development by anisotropic dry etching enables finer processing.

The dry etching is not particularly limited, and a known method, such as chemical etching, physical sputtering, or reactive ion etching (RIE), can be used. Among these, the dry etching is preferably reactive ion etching (RIE), which can achieve a high etch rate.

As a reactive ion etching apparatus, it may be possible to use a plasma etching apparatus of a capacitively coupled plasma (CCP) type, an electron cyclotron resonance plasma (ECP) type, a helicon wave excited plasma (HWP) type, an inductively coupled plasma (ICP) type, a microwave excited surface wave plasma (SWP) type, or the like. Among them, an inductively coupled plasma etching apparatus or a capacitively coupled plasma etching apparatus can be suitably used as the plasma etching apparatus.

The dry etching can be performed in a chamber provided in a plasma etching apparatus using the resist film after the exposure to light or after the exposure to light and the PEB treatment.

The etch rate can be adjusted by using a halogen-containing gas, such as fluorocarbon, hydrofluorocarbon, a fluorine-based gas, a chlorine-based gas, or a bromide-based gas, as an etching gas.

The fluorocarbon is, for example, but not limited to, $CF_4$, $C_2F_6$, $C_3F_6$, $C_4F_8$, or the like, and the hydrofluorocarbon is, for example, but not limited to, $CF_3H$, $CF_2H_2$, $CF_4H_2$, $C_2F_5H$, $C_3F_7H$, $C_3F_6H_2$, $C_3F_5H_3$, $C_3F_4H_4$, $C_3F_3H_5$, or the like.

The fluorine-based gas is, for example, but not limited to, $SF_6$, $NF_3$, $F_2$, or the like, the chlorine-based gas is, for example, but not limited to, $Cl_2$, $CHCl_3$, $SiCl_4$, $CCl_4$, $BCl_3$, or the like, and the bromide-based gas is, for example, but not limited to, $Br_2$, HBr, or the like.

These halogen-containing gases may be used alone or in combination of two or more types thereof.

The etching gas may contain an oxidizing gas, an inert gas, or the like as an additive gas. The oxidizing gas is, for example, but not limited to, $O_2$, $O_3$, CO, $CO_2$, $COCl_2$, $COF_2$, NO, $NO_2$, SO, $SO_2$, COS, or the like. The inert gas is, for example, but not limited to, $N_2$, He, Ar, Ne, Kr, Xe, or the like. The etch rate can be adjusted by adding an oxidizing gas, and the safety of handling the etching gas can be improved by adding an inert gas.

The ratio of the halogen-containing gas to the additive gas (oxidizing gas and/or inert gas) in the etching gas is not particularly limited and may be 0 to 10:0 to 10, preferably 1 to 10:1 to 10, more preferably 1 to 5:1 to 5.

The treatment conditions of the development by dry etching can be appropriately determined so as to optimize the selection ratio of the etch rate in the unexposed portion and the exposed portion depending on the type of apparatus to be used, the type of etching gas, the type of polyacid salt in the resist film, and the like.

The flow rate of the etching gas preferably ranges from 3 to 1000 sccm, more preferably 5 to 800 sccm.

The dry etching temperature is, for example, but not limited to, preferably in the range of -50°C to 300°C, more preferably -20°C to 200°C, still more preferably -10°C to 100°C.

The pressure in the chamber is, for example, but not limited to, preferably in the range of 0.01 to 300 Pa, more preferably 0.05 to 100 Pa, still more preferably 0.1 to 30 Pa.

The radio-frequency (RF) power preferably ranges from 50 to 1500 W, more preferably 150 to 1000 W.

The bias power preferably ranges from 10 to 1000 W, more preferably 20 to 500 W.

The dry etching time can be appropriately determined within a range in which over-etching is performed to the extent that etching residue or side etching does not occur in a through-hole. The dry etching time can range from, for example, 10 to 90 seconds.

The selection ratio of the exposed portion and the unexposed portion of the resist film in dry etching can be represented by the following formula.

$$(\text{Selection ratio}) = (\text{etch rate in unexposed portion})/(\text{etch rate in exposed portion})$$

The etch rate in the unexposed portion or the exposed portion can be expressed as (etch rate (nm/min) = $\Delta$h x (60/t), wherein $\Delta$h (nm) denotes the difference in film thickness before and after dry etching for t seconds.

The selection ratio in the above case is preferably 1.1 or more, more preferably 1.2 or more, still more preferably 1.5 or more.

[3. Patterned Structure]

A patterned structure according to the present embodiment is produced by forming a pattern of the resist material on a substrate by the pattern forming method.

The average thickness of part or all of the patterned structure according to the present embodiment is not particularly limited and can be appropriately determined depending on the intended use or the like. The patterned structure preferably has a portion with an average thickness in the range of 10 to 100 nm, more preferably 15 to 75 nm. It is more preferable to have a portion with an average thickness in the range of 20 to 60 nm.

The pitch of part or all of the patterned structure according to the present embodiment is not particularly limited and can be appropriately determined depending on the intended use or the like. The patterned structure preferably has a portion with a pitch of 100 nm or less, more preferably has a portion with a pitch of 50 nm or less, and still more preferably has a portion with a pitch of 20 nm or less.

The resist material according to the present embodiment can be patterned by the pattern forming method to form a portion with a pitch of 50 nm, a portion with a pitch of 20 nm, and a portion with a pitch of 15 nm in part or all of the patterned structure.

[4. Resist Material for Electron Beam or EUV]

The resist material according to the present embodiment has high sensitivity to an electron beam and an EUV light source and therefore can be suitably used as a resist material for these exposure light sources.

## EXAMPLES

The present invention will be more specifically described below with reference to examples, but the present invention is not limited to these examples.

[1. Synthesis of Polyacid salt]

<Synthesis Example 1: hexakis(bis(2-trifluoromethylphenyl)phenylsulfonium)metatungstate (M-1)>

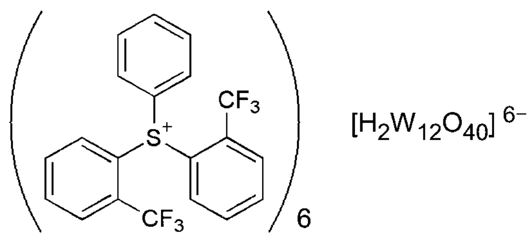

6.68 g of bis(2-trifluoromethylphenyl)phenylsulfonium chloride was dissolved in 99.36 g of pure water, 6.88 g of

an ammonium metatungstate (manufactured by Nippon Inorganic Colour & Chemical Co., Ltd.: an ammonium metatungstate hydrate ((NH4)6[H2W12O40]·xH2O)) was added thereto, and the reaction liquid was stirred at room temperature for 30 minutes. A powder produced by filtering the reaction liquid was dried under reduced pressure at room temperature for 18 hours. The dried powder was dissolved in 100 g of dimethylformamide, 335 g of methanol was then added thereto, and a target compound (M-1) was produced by crystallization at room temperature. $^1$H-NMR (400 MHz, DMSO-D6): δ (ppm) =5.97(s, 0.33H), 7.65-8.35(m, 13H). $^{183}$W-NMR (20.84 MHz, DMSO-D6): δ (ppm) = -100.13(s, 12W).
ESI-MS: POSITIVE m/z 399.1 ($[C_{20}H_{13}F_6S]^+$)
NEGATIVE m/z 712.3 (median) ($[H_4W_{12}O_{40}]^{4-}$)

[2. Preparation of Resist Material]

As a resist material, a resist material R was prepared by blending M-1 synthesized above and organic solvents 1 and 2 in amounts (unit: parts by mass) shown in Table 1 below.

[Table 1]

| Resist material | Polyacid salt | Organic solvent 1 | Organic solvent 2 |
|---|---|---|---|
| R | M-1 | DMF | EL |
| | 3 parts by mass | 10 parts by mass | 90 parts by mass |

[3. LS Pattern Formation 1]

The resist material R was applied using a spinner to an 8-inch silicon substrate subjected to a hexamethyldisilazane (HMDS) treatment, was subjected to a post-apply bake (PAB) treatment on a hot plate at a temperature of 200°C for 60 seconds, and was dried to form a resist film with a thickness of 50 nm. The thickness of the formed resist film was measured with a thickness measuring apparatus ("M-2000D" manufactured by J. A. Woollam).
Drawing (exposure to light) was performed on the resist film using an electron-beam lithography system F7000S-VD2 (manufactured by Advantest Corporation) at an accelerating voltage of 50 kV such that the target size was a 1:1 line-and-space pattern (hereinafter also referred to as an "LS pattern") with a line width of 50 nm. The exposure level is shown in Table 2. A post-exposure bake (PEB) treatment was then performed at a predetermined temperature shown in Table 2 for 60 seconds.
Development with a developer B (DMF (10 parts by mass), IPA (90 parts by mass)) was then performed at 23°C for 60 seconds, and rinsing with IPA was performed for 60 seconds.
Thus, a 1:1 LS pattern with a line width of 50 nm was formed, and LS patterns 1 and 2 were formed. These are negative patterns.

<Evaluation of Shape of LS Pattern>

The shapes of the LS patterns 1 and 2 were observed by critical dimension scanning electron microscopy (SEM) (accelerating voltage: 10 kV, trade name: SU-5000, manufactured by Hitachi High-Tech Corporation) and were evaluated in accordance with the following criteria. Table 2 shows the results. Furthermore, SEM images of a cross section and an upper surface of the LS patterns 1 and 2 are shown in the drawing and Fig. 2, respectively.

Good: Almost no tailing was observed in the LS pattern of the SEM image, and the resolution was good.
Fair: The LS pattern is resolved in part of the SEM image (a portion bonded to part of an adjacent line pattern is observed in some places).
Poor: The LS pattern is not formed (not resolved) in the entire SEM image.

[Table 2]

| | Resist material | Developer | PEB temperature (°C) | Exposure level (μC/cm$^2$) | Evaluation of Shape |
|---|---|---|---|---|---|
| LS pattern 1 | R | B | 190 | 425 | Good |
| LS pattern 2 | | | 180 | 425 | Good |

Figs. 1 and 2 show that a resist material containing a polyacid salt can be used to form an LS pattern with a line width of 50 nm and with almost no tailing at a high resolution.

[4. LS Pattern Formation 2]

A resist film with a thickness of 50 nm was formed in the same manner as in LS Pattern Formation 1 except that the application target was changed to a silicon wafer substrate.

The resist film was exposed to light through a mask using an EUV exposure apparatus while changing the exposure level stepwise. After a PEB treatment at 180°C for 60 seconds, development with the developer B was performed at 23°C for 60 seconds, and rinsing with IPA was performed for 60 seconds. Thus, a negative 1:1 LS pattern with a line width of 35 nm was formed. The optimum exposure level Eop ($mJ/cm^2$) with which an LS pattern with the target size was formed was determined to be 115 $mJ/cm^2$.

As a result of evaluating the LS pattern shape in the same manner as in LS Pattern Formation 1, it was confirmed that tailing was rarely observed in the LS pattern of a SEM image, and the resolution was good.

[5. Synthesis of Polyacid Salt 2]

Polyacid salts (M-2) to (M-10) were synthesized by the following method.

<Synthesis Example 2: hexakis(bis(5-t-butylphenyl)iodonium)metatungstate (polyacid salt (M-2))>

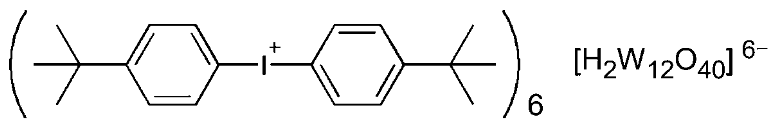

A target compound (M-2) was prepared in the same manner as in Synthesis Example 1 except that bis(4-t-butylphenyl)iodonium triflate was used as a raw material compound instead of bis(2-trifluoromethylphenyl)phenylsulfonium chloride.

$^1$H-NMR (400 MHz, DMSO-D6): δ (ppm) =1.22(s, 18H), 5.97(s, 0.33H), 7.51(d, 4H), 8.19(d, 4H).

$^{183}$W-NMR (20.84 MHz, DMSO-D6): δ (ppm) = -95.39(s, 12W).
ESI-MS: POSITIVE m/z 393.1 ($[C_{20}H_{26}I]^+$)
NEGATIVE m/z 712.3 (median) ($[H_4W_{12}O_{40}]^{4-}$)

<Synthesis Example 3: hexakis(triethylhexylammonium)metatungstate (polyacid salt (M-3))>

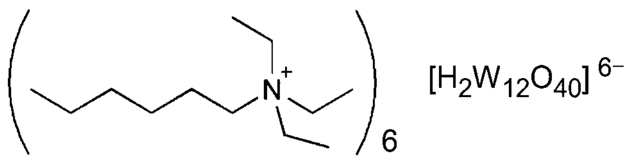

A target compound (M-3) was prepared in the same manner as in Synthesis Example 1 except that triethylhexylammonium bromide was used as a raw material compound instead of bis(2-trifluoromethylphenyl)phenylsulfonium chloride.

$^1$H-NMR (400 MHz, DMSO-D6): δ (ppm) =0.88(t, 3H), 1.17-1.21(m, 9H), 1.31(br, 6H), 1.58(br, 2H), 3.10-3.14(m, 2H), 3.26(q, 6H), 5.97(s, 0.33H).

$^{183}$W-NMR (20.84 MHz, DMSO-D6): δ (ppm) = -100.13(s, 12W).
ESI-MS: POSITIVE m/z 186.2 ($[C_{12}H_{28}N]^+$)
NEGATIVE m/z 712.3 (median) ($[H_4W_{12}O_{40}]^{4-}$)

<Synthesis Example 4: bis(bis(2-trifluoromethylphenyl)phenylsulfonium)hexatungstate (polyacid salt (M-4))>

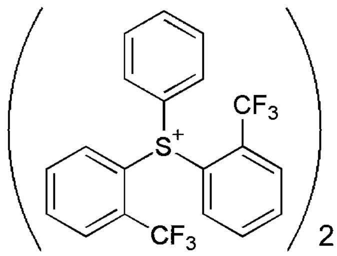

$[W_6O_{19}]^{2-}$

A target compound (M-4) was prepared in the same manner as in Synthesis Example 1 except that bis(tetrabutylammonium)hexatungstate was used as a raw material compound instead of ammonium metatungstate.

$^{1}$H-NMR (400 MHz, DMSO-D6): δ (ppm) =7.65-8.35(m, 13H).

$^{183}$W-NMR (20.84 MHz, DMSO-D6): δ (ppm) = +59.84(s, 6W).

ESI-MS: POSITIVE m/z 399.1 ($[C_{20}H_{13}F_6S]^+$)

NEGATIVE m/z 703.8 (median) ($[W_6O_{19}]^{2-}$)

<Synthesis Example 5: tetrakis(bis(2-trifluoromethylphenyl)phenylsulfonium)silicotungstate (polyacid salt (M-5)>

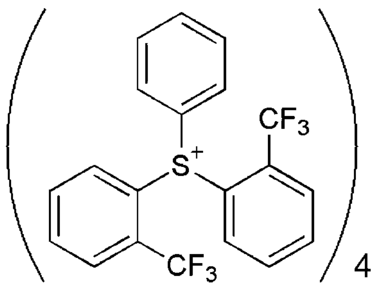

$[SiW_{12}O_{40}]^{4-}$

A target compound (M-5) was prepared in the same manner as in Synthesis Example 1 except that silicotungstic acid ($H_4[SiW_{12}O_{40}]\cdot 26H_2O$) was used as a raw material compound instead of ammonium metatungstate.

$^{1}$H-NMR (400 MHz, DMSO-D6): δ (ppm) =7.65-8.35(m, 13H).

$^{183}$W-NMR (20.84 MHz, DMSO-D6): δ (ppm) = -92.7(s, 12W).

ESI-MS: POSITIVE m/z 399.1 ($[C_{20}H_{13}F_6S]^+$)

NEGATIVE m/z 718.5 (median) ($[SiW_{12}O_{40}]^{4-}$)

<Synthesis Example 6: hexakis((4-(2-((1-ethylcyclopentyl)oxy)-2-oxoethoxy)-3,5-dimethylphenyl)diphenylsulfonium) metatungstate (polyacid salt (M-6))>

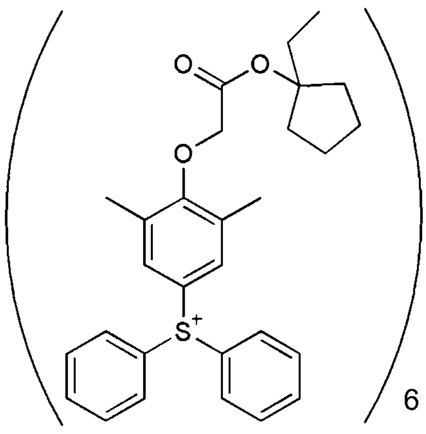

$[H_2W_{12}O_{40}]^{6-}$

A target compound (M-6) was prepared in the same manner as in Synthesis Example 1 except that (4-(2-((1-ethylcyclopentyl)oxy)-2-oxoethoxy)-3,5-dimethylphenyl)diphenylsulfonium bromide was used as a raw material compound instead of bis(2-trifluoromethylphenyl)phenylsulfonium chloride.

$^1$H-NMR (400 MHz, DMSO-D6): δ (ppm) =0.77-0.81(t, 3H), 1.48-1.75(m, 6H), 1.90-1.93(m, 4H), 2.29(m, 6H), 4.55(s, 2H), 5.97(s, 0.33H), 7.59(s, 2H), 7.76-7.82(m, 10H). $^{183}$W-NMR (20.84 MHz, DMSO-D6): δ (ppm) = -100.13(s, 12W).
ESI-MS: POSITIVE m/z 461.2 ($[C_{29}H_{33}O_3S]^+$)
NEGATIVE m/z 712.3 (median) ($[H_4W_{12}O_{40}]^{4-}$)

<Synthesis Example 7: bis((4-(2-((1-ethylcyclopentyl)oxy)-2-oxoethoxy)-3,5-dimethylphenyl)diphenylsulfonium)hexatungstate (polyacid salt (M-7))>

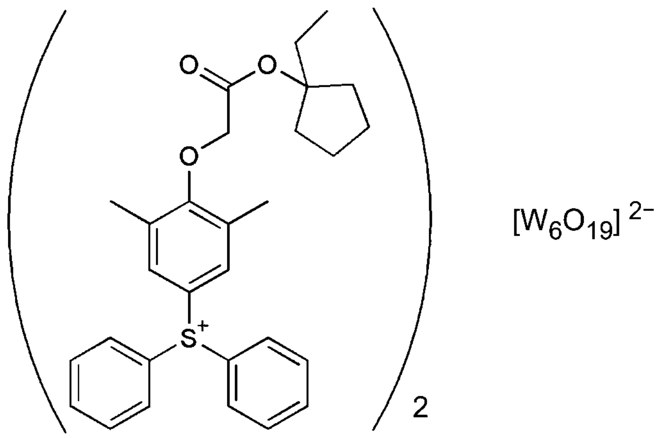

A target compound (M-7) was prepared in the same manner as in Synthesis Example 1 except that (4-(2-((1-ethylcyclopentyl)oxy)-2-oxoethoxy)-3,5-dimethylphenyl)diphenylsulfonium bromide was used as a raw material compound instead of bis(2-trifluoromethylphenyl)phenylsulfonium chloride and bis(tetrabutylammonium)hexatungstate was used as a raw material compound instead of ammonium metatungstate.

$^1$H-NMR (400 MHz, DMSO-D6): δ (ppm) =0.77-0.81(t, 3H), 1.48-1.75(m, 6H), 1.90-1.93(m, 4H), 2.29(m, 6H), 4.55(s, 2H), 7.59(s, 2H), 7.76-7.82(m, 10H).

$^{183}$W-NMR (20.84 MHz, DMSO-D6): δ (ppm) =+59.84(s, 6W).
ESI-MS: POSITIVE m/z 461.2 ($[C_{29}H_{33}O_3S]^+$)
NEGATIVE m/z 703.8 (median) ($[W_6O_{19}]^{2-}$)

<Synthesis Example 8: tetrakis((4-(2-((1-ethylcyclopentyl)oxy)-2-oxoethoxy)-3,5-dimethylphenyl)diphenylsulfonium)silicotungstate (polyacid salt (M-8))>

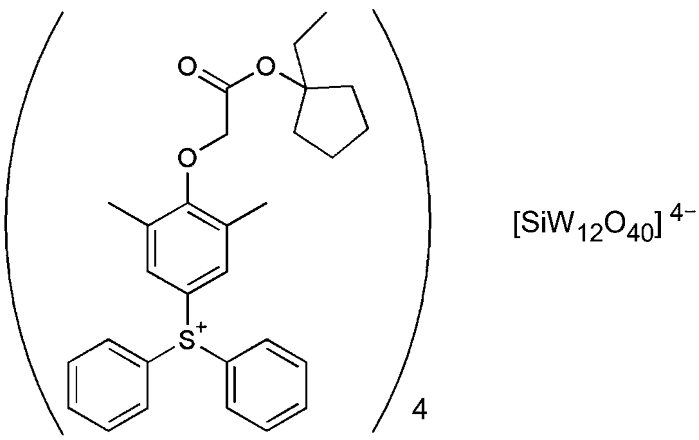

A target compound (M-8) was prepared in the same manner as in Synthesis Example 1 except that (4-(2-((1-ethylcyclopentyl)oxy)-2-oxoethoxy)-3,5-dimethylphenyl)diphenylsulfonium bromide was used as a raw material compound instead of bis(2-trifluoromethylphenyl)phenylsulfonium chloride and silicotungstic acid ($H_4[SiW_{12}O_{40}]\cdot 26H_2O$) was used as a raw material compound instead of ammonium metatungstate.

$^1$H-NMR (400 MHz, DMSO-D6): δ (ppm) =0.77-0.81(t, 3H), 1.48-1.75(m, 6H), 1.90-1.93(m, 4H), 2.29(m, 6H), 4.55(s, 2H), 7.59(s, 2H), 7.76-7.82(m, 10H).

$^{183}$W-NMR (20.84 MHz, DMSO-D6): δ (ppm) =-92.7(s, 12W).
ESI-MS: POSITIVE m/z 461.2 ($[C_{29}H_{33}O_3S]^+$)
NEGATIVE m/z 718.5 (median) ($[SiW_{12}O_{40}]^{4-}$)

<Synthesis Example 9: tris((4-(2-((1-ethylcyclopentyl)oxy)-2-oxoethoxy)-3,5-dimethylphenyl)diphenylsulfonium)phosphotungstate (polyacid salt (M-9))>

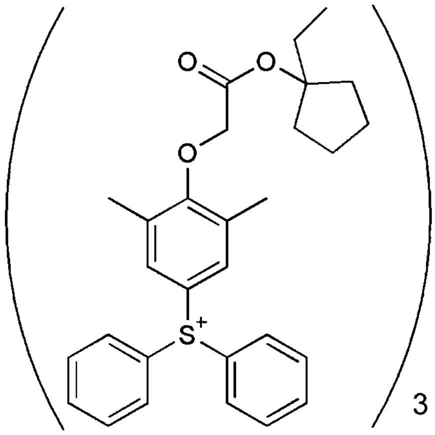

$[PW_{12}O_{40}]^{3-}$

A target compound (M-9) was prepared in the same manner as in Synthesis Example 1 except that (4-(2-((1-ethylcyclopentyl)oxy)-2-oxoethoxy)-3,5-dimethylphenyl)diphenylsulfonium bromide was used as a raw material compound instead of bis(2-trifluoromethylphenyl)phenylsulfonium chloride and phosphotungstic acid ($H_3[PW_{12}O_{40}]\cdot 30H_2O$) was used as a raw material compound instead of ammonium metatungstate.

$^1$H-NMR (400 MHz, DMSO-D6): δ (ppm) =0.77-0.81(t, 3H), 1.48-1.75(m, 6H), 1.90-1.93(m, 4H), 2.29(m, 6H), 4.55(s, 2H), 7.59(s, 2H), 7.76-7.82(m, 10H).

$^{183}$W-NMR (20.84 MHz, DMSO-D6): δ (ppm) =-86.7(s, 12W).
ESI-MS: POSITIVE m/z 461.2 ($[C_{29}H_{33}O_3S]^+$)
NEGATIVE m/z 959 (median) ($[PW_{12}O_{40}]^{3-}$)

<Synthesis Example 10: pentakis(bis(2-trifluoromethylphenyl)phenylsulfonium)metatungstate (polyacid salt (M-10))>

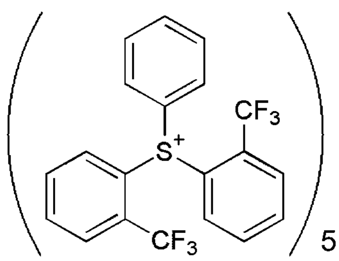

$[H_3W_{12}O_{40}]^{5-}$

10 g of water and 10 g of 1 mol/L aqueous hydrochloric acid were added to 16.67 g of ammonium metatungstate (ammonium metatungstate hydrate ($(NH_4)6[H_2W_{12}O_{40}]\cdot xH_2O$) and were stirred at room temperature for 60 minutes. An aqueous solution of 13.47 g of bis(2-trifluoromethylphenyl)phenylsulfonium chloride in 200 g of pure water was then added to this reaction liquid and was stirred at room temperature for 30 minutes. A powder prepared by filtering the reaction liquid was dried under reduced pressure at room temperature for 18 hours. The dried powder was dissolved in 100 g of

dimethylformamide, 335 g of methanol was then added thereto, and a target compound (M-10) was produced by crystallization at room temperature. $^{1}$H-NMR (400 MHz, DMSO-D6): δ (ppm) =6.77(s, 0.60H), 7.65-8.35(m, 13H). $^{183}$W-NMR (20.84 MHz, DMSO-D6): δ (ppm) = -87.59(s, 12W).
ESI-MS: POSITIVE m/z 399.1 ($[C_{20}H_{13}F_6S]^+$)
NEGATIVE m/z 712.3 (median) ($[H_4W_{12}O_{40}]^{4-}$)

[6. Preparation of Resist Material 2]

As resist materials, resist materials R-2 to R-9 were prepared by blending the polyacid salts M-2 to M-9 synthesized above and the organic solvents 1 and 2 in amounts (unit: parts by mass) shown in Table 3 below. In Table 3, DMF means N,N-dimethylformamide, EL means ethyl lactate, and CH means cyclohexanone.

[Table 3]

| Resist material | Polyacid salt | Organic solvent 1 | Organic solvent 2 |
|---|---|---|---|
| R-2 | M-2 | DMF | EL |
| | 3 parts by mass | 10 parts by mass | 90 parts by mass |
| R-3 | M-3 | DMF | EL |
| | 3 parts by mass | 10 parts by mass | 90 parts by mass |
| R-4 | M-4 | DMF | EL |
| | 3 parts by mass | 10 parts by mass | 90 parts by mass |
| R-5 | M-5 | CH | EL |
| | 3 parts by mass | 10 parts by mass | 90 parts by mass |
| R-6 | M-6 | CH | EL |
| | 3 parts by mass | 10 parts by mass | 90 parts by mass |
| R-7 | M-7 | CH | EL |
| | 3 parts by mass | 10 parts by mass | 90 parts by mass |
| R-8 | M-8 | CH | EL |
| | 3 parts by mass | 10 parts by mass | 90 parts by mass |
| R-9 | M-9 | CH | EL |
| | 3 parts by mass | 10 parts by mass | 90 parts by mass |

[7. LS Pattern Formation 3]

<Preparation of LS Pattern>

Each of the resist materials R-2 to R-9 was applied using a spinner to an 8-inch silicon substrate subjected to a hexamethyldisilazane (HMDS) treatment, was subjected to a post-apply bake (PAB) treatment on a hot plate at a temperature of 200°C for 60 seconds, and was dried to form a resist film with a thickness of 50 nm. The thickness of the formed resist film was measured with a thickness measuring apparatus ("M-2000D" manufactured by J. A. Woollam).

Drawing (exposure to light) was performed on the resist film using an electron-beam lithography system F7000S-VD2 (manufactured by Advantest Corporation) at an accelerating voltage of 50 kV such that the target size was a 1:1 line-and-space pattern (hereinafter also referred to as an "LS pattern") with a line width of 50 nm. The exposure level is shown in Table 4. A post-exposure bake (PEB) treatment was then performed at a predetermined temperature shown in Table 4 for 60 seconds.

The exposed and PEB-treated resist films prepared using the resist materials R-2 to R-4 were then developed with the developer B (DMF (10 parts by mass), IPA (90 parts by mass)) at 23°C for 60 seconds and were rinsed with IPA for 60 seconds.

Furthermore, the exposed and PEB-treated resist films prepared using the resist materials R-5 to R-9 were subjected to alkaline development with a 2.38% by mass TMAH aqueous solution (trade name: NMD-3, manufactured by Tokyo Ohka Kogyo Co., Ltd.) at 23°C for 60 seconds and were then rinsed with pure water for 15 seconds.

Thus, a 1:1 LS pattern with a line width of 50 nm was formed, and negative LS patterns (LS-2 to LS-4) and positive LS patterns (LS-5 to LS-9) were formed.

<Evaluation of Shape of LS Pattern>

The shapes of LS-2 to LS-9 were observed by critical dimension scanning electron microscopy (SEM) (accelerating voltage: 10 kV, trade name: SU-5000, manufactured by Hitachi High-Tech Corporation) and were evaluated in accordance with the following criteria. Table 4 shows the results.

Good: Almost no tailing was observed in the LS pattern of the SEM image, and the resolution was good.
Fair: The LS pattern is resolved in part of the SEM image (a portion bonded to part of an adjacent line pattern is observed in some places).
Poor: The LS pattern is not formed (not resolved) in the entire SEM image.

[Table 4]

| LS pattern | Resist material | Developer 1 | Developer 2 | PEB temperature | Pattern | Exposure level | Shape |
|---|---|---|---|---|---|---|---|
| LS-2 | R-2 | DMF | IPA | 150 | Negative | 650 | Good |
| LS-3 | R-3 | DMF | IPA | 200 | Negative | 980 | Fair |
| LS-4 | R-4 | DMF | IPA | 140 | Negative | 550 | Fair |
| LS-5 | R-5 | TMAH | - | 90 | Positive | 650 | Fair |
| LS-6 | R-6 | TMAH | - | 90 | Positive | 500 | Fair |
| LS-7 | R-7 | TMAH | - | 90 | Positive | 750 | Fair |
| LS-8 | R-8 | TMAH | - | 90 | Positive | 250 | Good |
| LS-9 | R-9 | TMAH | - | 90 | Positive | 260 | Good |

The results in Table 4 show that the resist materials containing polyacid salts can form positive and negative patterns. Furthermore, by appropriately selecting the combination of the cation moiety and the anion moiety of the polyacid salt, the PEB temperature, the exposure level, and the like, it is possible to form an LS pattern with high resolution in which tailing is only slightly or rarely observed.

[8. Formation of Resist Pattern by Dry Etching]

As resist materials, resist materials R'-1 and R'-2 were prepared by blending a polyacid salt and organic solvents 1 to 3 in amounts (unit: parts by mass) shown in Table 5 below. In Table 5, HBN means 4-hydroxy-2-butanone, DAA means diacetylacetone, and CP means cyclopentanone.

[Table 5]

| Resist material | Polyacid salt | Organic solvent 1 | Organic solvent 2 | Organic solvent 3 |
|---|---|---|---|---|
| R'-2 | M-10 | HBN | DAA | EL |
| | 3 parts by mass | 10 parts by mass | 80 parts by mass | 10 parts by mass |
| R'-3 | M-4 | CP | | |
| | 3 parts by mass | 100 parts by mass | | |

Each of the resist materials R'-1 and R'-2 was applied to a silicon wafer by a spin coating method using ACT8 (manufactured by Tokyo Electron Ltd.), was then prebaked on a hot plate at a predetermined temperature (PAB) shown in Table 6 for 60 seconds, and was dried to form a resist film with a thickness of 40 nm.

The resist film was then selectively exposed to light using a KrF exposure apparatus NSR-S203B (manufactured by Nikon Corporation).

A post-exposure bake (PEB) treatment was then performed at a predetermined temperature shown in Table 6 for

60 seconds.

The resist film subjected to the post-exposure heat treatment was developed by dry etching under various conditions shown in Table 6 to form resist patterns (pattern 1-1 to pattern 12-1). For the development by dry etching, a plasma etching apparatus (inductively coupled plasma (ICP)) was used.

The development by the dry etching was performed under the conditions of a radiofrequency (RF) power of 100 W, a bias power of 25 W, a stage temperature of 0°C, and a treatment pressure of 2.4 Pa by adjusting the ratio of CF4, C4F8, and $O_2$ shown in Table 6 so that the total gas flow rate became 100 sccm or by adjusting the ratio of C12 and $O_2$ shown in Table 6 so that the total gas flow rate became 50 sccm.

The development by dry etching was performed for a development time determined in advance according to the following procedure.

Procedure (1): The thickness of the resist film subjected to the post-exposure heat treatment before dry etching was measured.

Procedure (2): The resist film was developed by dry etching for 40 seconds under the above conditions.

Procedure (3): The thickness of a resist residual film after the development by etching was measured, and the selection ratio of the etch rate in the exposed portion and the unexposed portion of the resist film was calculated using the following formula.

Table 6 shows the results.

A: Etch rate in unexposed portion (= difference in film thickness in unexposed portion before and after development by dry etching (nm)/40 (sec) x 60 (sec)).

B: Etch rate in exposed portion (= difference in film thickness in exposed portion before and after development by dry etching (nm)/40 (sec) x 60 (sec)).

C: Selection ratio (= A/B) in etch rate of unexposed portion and exposed portion

<Various Conditions of Dry Etching or the Like and Evaluation of Selection Ratio>

[Table 6]

| Pattern | Resist material | Conditions for preparing unexposed portion and exposed portion | | | Dry etching conditions | | | Selection ratio of etch rate in unexposed portion and exposed portion (C) |
|---|---|---|---|---|---|---|---|---|
| | | PAB | Exposure level | PEB | Gas-1 | Gas-2 | Gas-1/Gas-2 (ratio) | |
| Pattern 1-1 | R'-1 | 180°C | 70 mJ | 180°C | $CF_4$ | $O_2$ | 100/0 | 1.5 |
| Pattern 1-2 | | | | | | | 90/10 | 1.5 |
| Pattern 1-3 | | | | | | | 75/25 | 1.9 |
| Pattern 1-4 | | | | | | | 50/50 | 1.7 |
| Pattern 1-5 | | | | | | | 25/75 | 1.9 |
| Pattern 2-1 | R'-1 | 180°C | 70 mJ | 180°C | $C_4F_8$ | $O_2$ | 70/30 | 7.2 |
| Pattern 2-2 | | | | | | | 60/40 | 1.5 |
| Pattern 2-3 | | | | | | | 50/50 | 1.9 |
| Pattern 2-4 | | | | | | | 35/65 | 1.5 |
| Pattern 2-5 | | | | | | | 25/75 | 1.6 |
| Pattern 2-6 | | | | | | | 10/90 | 1.5 |

(continued)

| Pattern | Resist material | Conditions for preparing unexposed portion and exposed portion | | | Dry etching conditions | | | Selection ratio of etch rate in unexposed portion and exposed portion (C) |
|---|---|---|---|---|---|---|---|---|
| | | PAB | Exposure level | PEB | Gas-1 | Gas-2 | Gas-1/Gas-2 (ratio) | |
| Pattern 3-1 | R'-1 | 180°C | 70 mJ | 180°C | $CF_4/C_4F_8$ (50/50) | $O_2$ | 100/0 | 1.7 |
| Pattern 3-2 | | | | | | | 90/10 | 1.5 |
| Pattern 3-3 | | | | | | | 75/25 | 1.9 |
| Pattern 3-4 | | | | | | | 65/35 | 1.6 |
| Pattern 3-5 | | | | | | | 50/50 | 1.5 |
| Pattern 3-6 | | | | | | | 28/72 | 1.5 |
| Pattern 4-1 | R'-1 | 180°C | 70 mJ | 180°C | $Cl_2$ | $O_2$ | 100/0 | 1.7 |
| Pattern 4-2 | | | | | | | 75/25 | 7.1 |
| Pattern 4-3 | | | | | | | 50/50 | 4.4 |
| Pattern 4-4 | | | | | | | 25/75 | 3.5 |
| Pattern 4-5 | | | | | | | 5/95 | 4.1 |
| Pattern 5-1 | R'-2 | 180°C | 70 mJ | 180°C | $CF_4$ | $O_2$ | 100/0 | 4.0 |
| Pattern 5-2 | | | | | | | 75/25 | 1.6 |
| Pattern 5-3 | | | | | | | 50/50 | 1.6 |
| Pattern 5-4 | | | | | | | 25/75 | 1.5 |
| Pattern 6-1 | R'-2 | 180°C | 110 mJ | 180°C | $CF_4$ | $O_2$ | 100/0 | 1.5 |
| Pattern 6-2 | | | | | | | 75/25 | 1.8 |
| Pattern 6-3 | | | | | | | 50/50 | 1.6 |
| Pattern 6-4 | | | | | | | 25/75 | 1.7 |
| Pattern 7-1 | R'-2 | 100°C | 70 mJ | 100°C | $CF_4$ | $O_2$ | 100/0 | 1.5 |
| Pattern 7-2 | | | | | | | 75/25 | 1.6 |
| Pattern 7-3 | | | | | | | 50/50 | 1.5 |
| Pattern 7-4 | | | | | | | 25/75 | 1.5 |
| Pattern 8-1 | R'-2 | 100°C | 110 mJ | 100°C | $CF_4$ | $O_2$ | 100/0 | 2.1 |
| Pattern 8-2 | | | | | | | 75/25 | 1.5 |
| Pattern 8-3 | | | | | | | 50/50 | 1.5 |
| Pattern 8-4 | | | | | | | 25/75 | 1.6 |
| Pattern 9-1 | R'-2 | 180°C | 70 mJ | 180°C | $Cl_2$ | $O_2$ | 100/0 | 2.5 |
| Pattern 10-1 | R'-2 | 180°C | 110 mJ | 180°C | $Cl_2$ | $O_2$ | 100/0 | 2.5 |
| Pattern 11-1 | R'-2 | 100°C | 70 mJ | 100°C | $Cl_2$ | $O_2$ | 100/0 | 2.1 |
| Pattern 12-1 | R'-2 | 100°C | 110 mJ | 100°C | $Cl_2$ | $O_2$ | 100/0 | 1.7 |

Table 6 shows that the unexposed portion can be more selectively etched by adjusting the ratio of a halogen-containing gas, an oxidizing gas, and the like contained in the etching gas (for example, patterns 1-1 to 4-5). Furthermore, it can be seen that the selection ratio of the etch rate in the unexposed portion and the exposed portion can also be improved by adjusting the temperatures of PAB and PEB, the exposure level, and the like (for example, patterns 9-1 to 12-1 and the

like). Furthermore, it is generally known that the release process of the reaction product can be controlled by the pressure, the temperature, the vapor pressure of the reaction product, and the like in the chamber, and by adjusting these, the unexposed portion and the exposed portion can be further selectively etched in the resist film containing the polyacid salt.

## Claims

1. A resist material comprising a polyacid salt.

2. The resist material according to claim 1, wherein the polyacid salt is a salt with an onium cation.

3. The resist material according to claim 1, wherein the polyacid salt is a salt with an onium cation, and the onium cation has at least one optionally substituted unsaturated bond.

4. The resist material according to claim 1, further comprising an organic solvent.

5. The resist material according to claim 4, wherein the organic solvent is a polar solvent.

6. The resist material according to claim 1, wherein the polyacid salt is a salt of an isopolyoxomolybdate anion, an isopolyoxotungstate anion, an isopolyoxoniobate anion, an isopolyoxotantalate anion, a heteropolyoxomolybdate anion, a heteropolyoxotungstate anion, a heteropolyoxovanadate anion, a heteropolyoxoniobate anion, or a heteropolyoxotantalate anion, and an organic sulfonium cation, an organic iodonium cation, or an organic quaternary ammonium cation.

7. A pattern forming method comprising the steps of:

   forming a resist film using the resist material according to any one of claims 1 to 6; exposing the resist film to light; and
   developing the exposed resist film with a developer.

8. The pattern forming method according to claim 7, wherein the step of exposing the resist film to light comprises a step of exposing the resist film to an electron beam at a dose of 2 $mC/cm^2$ or less or extreme ultraviolet of 200 $mJ/cm^2$ or less.

9. The pattern forming method according to claim 7, wherein the developer contains an amide solvent, an ester solvent, a ketone solvent, or an alcohol solvent.

10. A pattern forming method comprising the steps of:

    forming a resist film using the resist material according to any one of claims 1 to 6; exposing the resist film to light; and
    developing the exposed resist film by dry etching.

11. The pattern forming method according to claim 10, wherein in the step of developing by dry etching, a gas containing a halogen-containing gas is used as an etching gas.

12. The pattern forming method according to claim 11, wherein the halogen-containing gas is fluorocarbon, hydrofluorocarbon, a fluorine-based gas, a chlorine-based gas, or a bromide-based gas.

13. A patterned structure obtained by patterning the resist material according to any one of claims 1 to 6.

14. A patterned structure, wherein the patterned structure according to claim 13 has a portion with an average thickness in the range of 5 to 100 nm.

15. The resist material according to any one of claims 1 to 6, which is a resist material for an electron beam or EUV.

**Fig. 1**

<LS pattern 1>

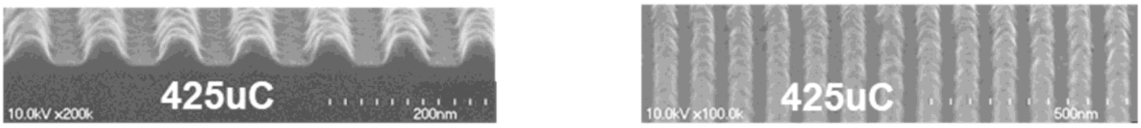


(Cross section) (Upper surface)

**Fig. 2**

<LS pattern 2>

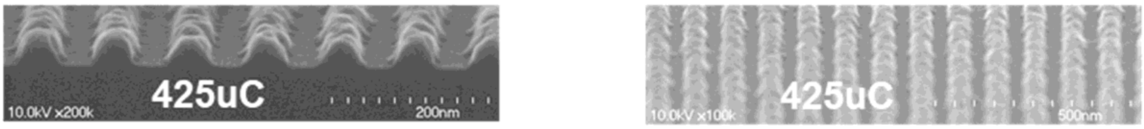


(Cross section) (Upper surface)

## INTERNATIONAL SEARCH REPORT

International application No.
**PCT/JP2024/018849**

**A. CLASSIFICATION OF SUBJECT MATTER**

***G03F 7/004***(2006.01)i; ***G03F 7/20***(2006.01)i; ***G03F 7/029***(2006.01)i
FI: G03F7/004 531; G03F7/20 521; G03F7/004; G03F7/20 501; G03F7/029

According to International Patent Classification (IPC) or to both national classification and IPC

**B. FIELDS SEARCHED**

Minimum documentation searched (classification system followed by classification symbols)

G03F7/004; G03F7/20; G03F7/029

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X | JP 61-036235 A (KABUSHIKI KAISHA TOSHIBA) 20 February 1986 (1986-02-20) claims, examples | 1-15 |
| X | WO 2015/053194 A1 (NISSAN CHEMICAL INDUSTRIES, LTD.) 16 April 2015 (2015-04-16) claims, examples | 1-2, 4-6, 10-15 |
| A | | 3, 7-9 |
| X | JP 05-501164 A (BOARD OF REGENTS, THE UNIVERSITY OF TEXAS SYSTEM) 04 March 1993 (1993-03-04) claims, examples | 1-2, 4-15 |
| A | | 3 |

☐ Further documents are listed in the continuation of Box C.    ☑ See patent family annex.

* Special categories of cited documents:
"A" document defining the general state of the art which is not considered to be of particular relevance
"D" document cited by the applicant in the international application
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **05 July 2024** | **23 July 2024** |
| Name and mailing address of the ISA/JP<br>**Japan Patent Office (ISA/JP)**<br>**3-4-3 Kasumigaseki, Chiyoda-ku, Tokyo 100-8915**<br>**Japan** | Authorized officer<br><br>Telephone No. |

Form PCT/ISA/210 (second sheet) (July 2022)

**INTERNATIONAL SEARCH REPORT**
**Information on patent family members**

International application No.
**PCT/JP2024/018849**

| Patent document cited in search report | Publication date (day/month/year) | Patent family member(s) | Publication date (day/month/year) |
|---|---|---|---|
| JP 61-036235 A | 20 February 1986 | (Family: none) | |
| WO 2015/053194 A1 | 16 April 2015 | US 2016/0251546 A1<br>claims, examples<br>CN 105612459 A<br>KR 10-2016-0065811 A<br>TW 201527432 A | |
| JP 05-501164 A | 04 March 1993 | US 5178989 A<br>claims, examples<br>DE 4091209 T<br>AU 6151890 A<br>CA 2063603 A | |

Form PCT/ISA/210 (patent family annex) (July 2022)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 11192908 B